# EUROPEAN PATENT APPLICATION

(11) **EP 4 852 002 A1**
(43) Date of publication of application: **09.12.2026**
(21) Application number: 26165245.7
(22) Date of filing: 16.03.2026
(51) Int. Cl.: G11C 16/04, G11C 16/08

(54) **MEMORY DEVICE WITH CELL STRINGS**

(30) Priority: 04.06.2025 KR 20250072844; 11.03.2026 US 202619563573
(71) Applicant: Samsung Electronics Co., Ltd., Suwon-si, Gyeonggi-do 16677 (KR)
(72) Inventor: MOON, Kibong, 16677 Suwon-si (KR); KIM, Kyoungwon, 16677 Suwon-si (KR); KIM, Soo Jin, 16677 Suwon-si (KR); PARK, Sang-Yong, 16677 Suwon-si (KR); BAIK, Seung Jae, 16677 Suwon-si (KR); IM, Younsoub, 16677 Suwon-si (KR)
(74) Representative: Marks & Clerk LLP

(57) **Abstract**

A memory device includes a substrate, a first cell string, and a second cell string. The first cell string includes a first string channel extending in a first direction parallel to the substrate, and the second cell string includes a second string channel extending in the first direction. Each of the first and second cell strings is connected between a first bit line and a common source line. First and second ground select transistors of ground select transistors in the first cell string have a first threshold voltage state, and third and fourth ground select transistors of ground select transistors in the second cell string have a second threshold voltage state. The first and third ground select transistors are connected to a first ground select line, and the second and fourth ground select transistors are connected to a second ground select line.

## Description

### FIELD

The present disclosure relates to a semiconductor memory, and more particularly, to a memory device.

### BACKGROUND

A semiconductor memory can be classified into volatile memory devices, such as Static Random Access Memory (SRAM) and Dynamic Random Access Memory (DRAM), in which stored data is lost when a power supply is turned off, and nonvolatile memory devices, such as flash memory, Phase-Change Random Access Memory (PRAM), Magnetoresistive Random Access Memory (MRAM), Resistive Random Access Memory (RRAM), and Ferroelectric Random Access Memory (FRAM), in which stored data is retained even when the power supply is turned off.

Flash memory devices are widely used as mass storage media. A flash memory device stores data or reads stored data by controlling the voltage levels of various lines (e.g., string select lines, word lines, ground select lines, etc.) connected to a plurality of memory cells. When these various lines are individually controlled at the cell string level, reliability and performance of the flash memory device can be improved. However, as the manufacturing process of the flash memory devices becomes more complex, it becomes increasingly difficult to form individual lines.

### SUMMARY

The present disclosure provides a memory device having improved performance and improved reliability.

According to some implementations of the present disclosure, a memory device includes a substrate; a first cell string including a first string channel extending in a first direction parallel to the substrate, a first string select transistor connected to a first string select line, and a plurality of ground select transistors respectively connected to a plurality of ground select lines; and a second cell string including a second string channel extending in the first direction, a second string select transistor connected to a second string select line, and a plurality of ground select transistors respectively connected to the plurality of ground select lines, wherein each of the first and second cell strings is connected between a first bit line and a common source line, wherein first and second ground select transistors of the plurality of ground select transistors in the first cell string have a first threshold voltage state, wherein third and fourth ground select transistors of the plurality of ground select transistors in the second cell string have a second threshold voltage state different from the first threshold voltage state, wherein the first and third ground select transistors are connected to a first ground select line of the plurality of ground select lines, and wherein the second and fourth ground select transistors are connected to a second ground select line of the plurality of ground select lines.

According to some implementations of the present disclosure, a memory device includes a substrate; a first cell string including a first string channel extending in a first direction parallel to the substrate, the first cell string being connected to a first bit line, a first string select line, and a plurality of ground select lines; and a second cell string including a second string channel extending in the first direction, the second cell string being connected to the first bit line, a second string select line, and the plurality of ground select lines, wherein based on the first cell string being selected, a first on-voltage is applied to first and second ground select lines of the plurality of ground select lines, and a second on-voltage lower than the first on-voltage is applied to remaining ground select lines, and wherein based on the second cell string being selected, the first on-voltage is applied to third and fourth ground select lines of the plurality of ground select lines, and the second on-voltage is applied to remaining ground select lines.

According to some implementations of the present disclosure, a memory device includes a substrate; and a plurality of first cell transistors connected in series in a first direction parallel to the substrate between a first bit line and a common source line, wherein the plurality of first cell transistors includes a plurality of first string select transistors, a plurality of first memory cells, and a plurality of first ground select transistors, and wherein at least two adjacent ground select transistors of the plurality of ground select transistors have a first program state, and the remaining first ground select transistors have an erase state.

According to the present disclosure, a memory device having improved performance and improved reliability is provided.

At least some of the above and other features of the invention are set out in the claims.

### BRIEF DESCRIPTION OF THE DRAWINGS

The foregoing and other features of the present disclosure will be described below in more detail with reference to the accompanying drawings of nonlimiting implementations of the present disclosure in which like reference characters refer to like parts throughout the different views. The drawings are not necessarily to scale, emphasis instead being placed upon illustrating principles of the present disclosure. In the drawings:
FIG. 1 is a block diagram illustrating a memory device according to some implementations of the present disclosure.
FIG. 2 is a diagram illustrating a memory block included in the memory device of FIG. 1.
FIGS. 3A and 3B are diagrams for describing a method of controlling the first memory block of FIG. 2.
FIGS. 4, 5, 6, 7, 8, 9, and 10 are diagrams illustrating a ground select transistor coding pattern (GCP) of ground select transistors of the first memory block of FIG. 2.
FIG. 11 is a circuit diagram illustrating a memory block included in the memory device of FIG. 1.
FIG. 12A is a diagram for describing a structure of the first memory block BLK1 of FIG. 2.
FIG. 12B is a diagram for explaining a structure of the second memory block of FIG. 11.
FIG. 13 is a diagram for describing a method of controlling the second memory block of FIG. 11.
FIG. 14 is a diagram for describing a structure in which a string channel is blocked in the second memory block of FIG. 11.
FIGS. 15, 16, 17, and 18 are diagrams illustrating a ground select transistor coding pattern (GCP) of ground select transistors of the second memory block of FIG. 11.
FIGS. 19A and 19B are diagrams illustrating a method of controlling the second memory block of FIG. 11.
FIG. 20 is a block diagram illustrating a host-storage system 2000 according to an example implementation of the present disclosure.

### DETAILED DESCRIPTION

Hereinafter, implementations of the present disclosure will be described clearly and in detail to the extent that a person skilled in the art can easily practice the present disclosure.

Terms such as "block," "unit or portion," "module," or the like, or configurations corresponding thereto, or functional blocks or circuits in the drawings, as used below, may be implemented in the form of software, hardware, or a combination thereof configured to perform or process various functions, operations, or features described in the detailed description.

Hereinafter, where various components are listed via the conjunction of "or," this may refer to each of the listed components, or to a combination of at least some. For example, "A, B, or C" can mean each of A, B, and C, or can mean a combination of A and B, a combination of B and C, a combination of A and C, and a combination of A, B, and C.

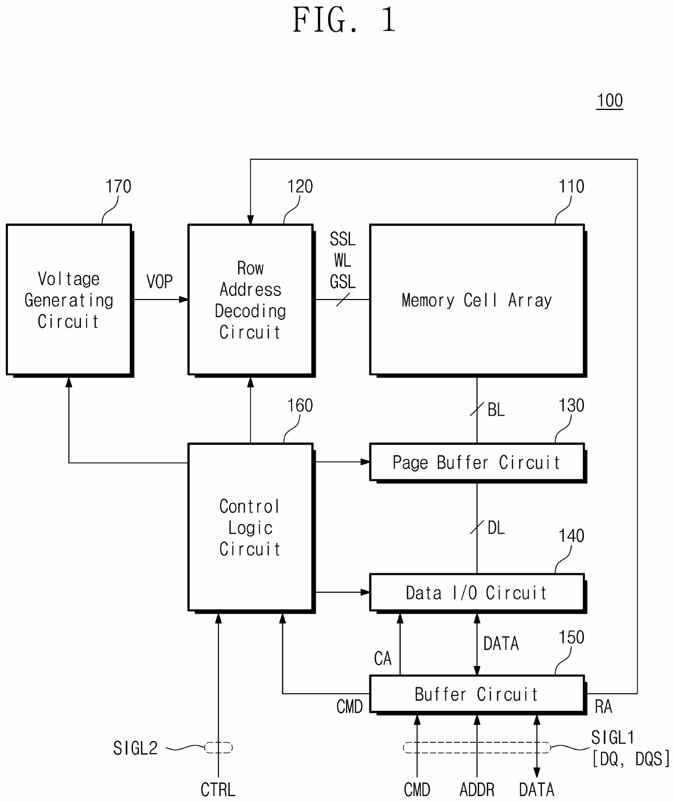

FIG. 1 is a block diagram illustrating a memory device according to some implementations of the present disclosure. Referring to FIG. 1, a memory device 100 may include a memory cell array 110, a row decoding circuit 120, a page buffer circuit 130, a data input/output circuit 140, a buffer circuit 150, a control logic circuit 160, and a voltage generation circuit 170. In some implementations, the memory device 100 may be a NAND flash memory. However, the scope of the present disclosure is not limited thereto, and the memory device 100 may be one of various other memory devices.

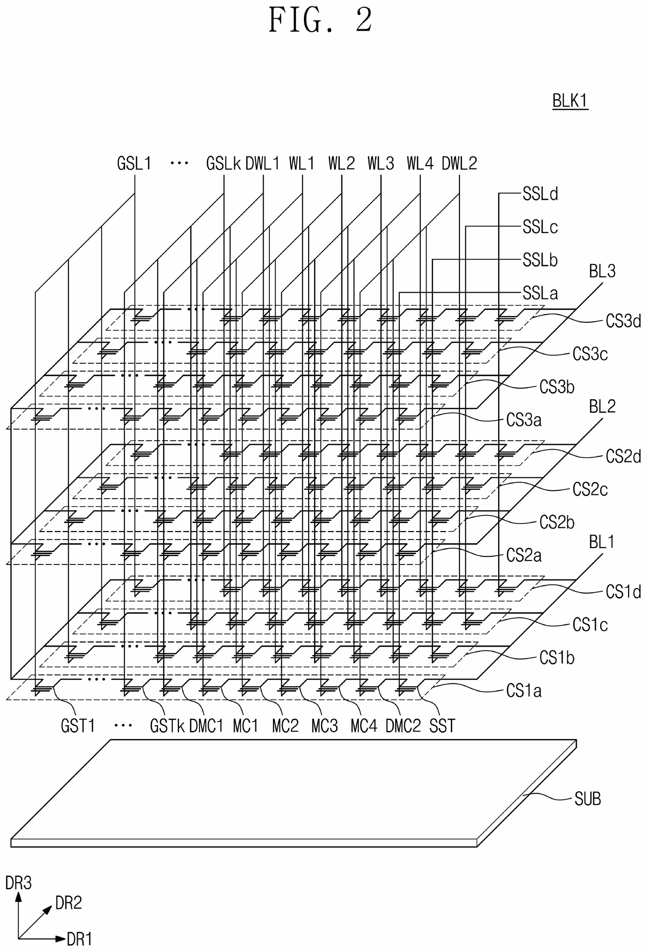

The memory cell array 110 may include a plurality of memory blocks. In some implementations, each of the plurality of memory blocks may have a three-dimensional structure stacked in a direction perpendicular to the substrate. Each of the plurality of memory blocks may include a plurality of cell strings. In some implementations, each of the plurality of cell strings may include a plurality of cell transistors arranged in a direction parallel to the substrate. A plurality of cell transistors may be connected in series between the bit lines BL and a common source line. The plurality of cell transistors may be connected to the string select lines SSL, the word lines WL, and the ground select lines GSL, respectively. The structure of each of the plurality of memory blocks is described in more detail with reference to the first memory block of FIG. 2.

The row decoding circuit 120 may be connected to the memory cell array 110 through string select lines SSL, word lines WL, and ground select lines GSL. The row decoding circuit 120 may operate under the control of the control logic circuit 160. For example, the row decoding circuit 123 may decode the row address RA received from the buffer circuit 150 under the control of the control logic circuit 160, and control or drive the string select lines SSL, the word lines WL, and the ground select lines GSL, or control voltages applied thereto, based on a decoding result.

The page buffer circuit 130 may be connected to the memory cell array 110 through bit lines BL. The page buffer circuit 130 may be connected to the data input/output circuit 140 through a plurality of data lines DL. The page buffer circuit 130 may operate under the control of the control logic circuit 160. For example, in a program operation of the memory device 100, the page buffer circuit 130 may store data to be programmed in the memory cell array 110 under the control of the control logic circuit 160. In a read operation of the memory device 100, the page buffer circuit 130 may sense voltages of the plurality of bit lines BL and store a sensing result as read data.

The data input/output circuit 140 may be connected to the page buffer circuit 130 through a plurality of data lines DL. The data input/output circuit 140 may receive the column address CA from the buffer circuit 150. The data input/output circuit 140 may transmit data, which is read by the page buffer circuit 130, to the buffer circuit 150 based on the column address CA. The data input/output circuit 140 may transmit data received from the buffer circuit 150 to the page buffer circuit 130 based on the column address CA.

The buffer circuit 150 may receive the command CMD and the address ADDR from the external device (e.g., the controller) through the first signal lines SIGL1, and may exchange data DATA with the external device (for example, the controller) via the first signal lines SIGL1. In some implementations, the first signal lines SIGL1 may include data signal lines (for example, DQ lines) and a data strobe signal line (for example, a DQS line).

The buffer circuit 150 may operate under the control of the control logic circuit 160. For example, the control logic circuit 160 may exchange the control signal CTRL with an external device (e.g., a controller) through the second signal lines SIGL2. The control logic circuit 160 may control the buffer circuit 150 to route the command CMD, the address ADDR, and the data DATA based on the control signal CTRL. The buffer circuit 150 may distinguish a signal received through the first signal lines SIGL1 into a command CMD or an address ADDR under the control of the control logic circuit 160. The buffer circuit 150 may transfer the command CMD to the control logic circuit 160. The buffer circuit 150 may transfer the row address RA of the address ADDR to the row decoding circuit 120, and transfer the column address CA of the address ADDR to the data input/output circuit 150. The buffer circuit 150 may exchange data DATA with the data input/output circuit 140.

The control logic circuit 160 may decode the command CMD received from the buffer circuit 150, and control the memory device 100 or various components of the memory device 100 based on a decoding result.

The voltage generation circuit 170 may generate various operating voltages VOP used in the memory device 100 under the control of the control logic circuit 160. In some implementations, the various operating voltages VOP may include various voltages such as program voltages, pass voltages, select read voltages, non-select read voltages, erase voltages, and verify voltages. Hereinafter, various voltages used to describe implementations of the present disclosure may be included in the operating voltages VOP generated by the voltage generation circuit 170.

FIG. 2 is a diagram illustrating a memory block included in the memory device of FIG. 1. For ease of description, the first memory block BLK1 is described with reference to FIG. 2. However, the scope of the present disclosure is not limited thereto, and other memory blocks of the memory device 100 may have a structure similar to that of the first memory block BLK1 of FIG. 2.

In some implementations, the first memory block BLK1 described with reference to FIG. 2 may be a physical erase unit of the memory device 100. However, the scope of the present disclosure is not limited thereto, and the memory device 100 may perform an erase operation in a page unit, a word line unit, a sub-block unit, a plane unit, or the like.

In some implementations, the first memory block BLK1 described with reference to FIG. 2 is a simplified example. The number of cell strings may be increased or decreased, and the number of rows and columns constituted by the cell strings may increase or decrease according to the number of cell strings. Alternatively, or additionally, the number of the cell transistors (for example, GST, MC, DMC, SST, ECT, etc.) of the first memory block BLK1 may be increased or decreased, respectively, and the height of the first memory block BLK1 may increase or decrease according to the number of cell strings. Alternatively, or additionally, the number of lines (for example, GSL, WL, DWL, SSL, etc.) connected to the cell transistors may be increased or decreased according to the number of the cell transistors.

Referring to FIGS. 1 and 2, the first memory block BLK1 may include a plurality of cell strings CS1a, CS1b, CS1c, CS1d, CS2a, CS2b, CS2c, CS2d, CS3a, CS3b, CS3c, and CS3d. The plurality of cell strings CS1a, CS1b, CS1c, CS1d, CS2a, CS2b, CS2c, CS2d, CS3a, CS3b, CS3c, and CS3d may be arranged in the second direction DR2 and the third direction DR3. In some implementations, the third direction DR3 may be a direction perpendicular to a plane formed in the first and second directions DR1 and DR2 or to the substrate SUB.

Each of the plurality of cell strings CS1a, CS1b, CS1c, CS1d, CS2a, CS2b, CS2c, CS2d, CS3a, CS3b, CS3c, and CS3d may include string channels formed in a direction parallel to the substrate SUB (for example, a first direction DR1). For example, each of the plurality of cell strings CS1a, CS1b, CS1c, CS1d, CS2a, CS2b, CS2c, CS2d, CS3a, CS3b, CS3c, and CS3d may include a plurality of cell transistors. A plurality of cell transistors included in one cell string may be arranged in the first direction DR1 and connected in series with each other. In this case, string channels included in each of the plurality of cell strings CS1a, CS1b, CS1c, CS1d, CS2a, CS2b, CS2c, CS2d, CS3a, CS3b, CS3c, and CS3d may be formed in the first direction DR1 parallel to the substrate SUB.

Hereinafter, for ease of description, the structure of the cell string is described with reference to the 1a-th cell string CS1a. However, the scope of the present disclosure is not limited thereto, and other cell strings may also have a similar structure.

The 1a-th cell string CS1a may include a plurality of cell transistors connected in series between the first bit line BL1 and the common source line CSL. The plurality of cell transistors may include ground select transistors GST1 to GSTk, a first dummy memory cell DMC1, memory cells MC1 to MC4, a second dummy memory cell DMC2, and a string select transistor SST.

A plurality of cell transistors (GST1 to GSTk, DMC1, MC1 to MC4, DMC2, SST, etc.) of the 1a-th cell string CS1a may be formed at the same height from the substrate SUB. The plurality of cell transistors (for example, GST1 to GSTk, DMC1, MC1 to MC4, DMC2, SST, etc.) may be electrically connected to corresponding lines (for example, GSL1 to GSLk, DWL1, WL1 to WL4, DWL2, SSL, etc.) through vertical gate plugs formed in a direction perpendicular to the substrate SUB (for example, the third direction DR3).

For example, the first ground select transistor GST1 may be electrically connected to the first ground select line GSL1 through a vertical gate plug formed in a direction perpendicular to the substrate SUB. In other words, the first ground select transistor GST1 may operate in response to the voltage of the first ground select line GSL1. In some implementations, other cell transistors may be connected similarly to the first ground select transistor GST1, and a detailed description thereof is omitted.

In some implementations, cell strings having the same height from the substrate SUB may be connected to the same bit line. For example, the 1a-th, 1b-th, 1c-th, and 1d-th cell strings CS1a, CS1b, CS1c, and CS1d, which are located at a first height from the substrate SUB, may be electrically connected to the first bit line BL1. The 2a-th, 2b-th, 2c-th, and 2d-th cell strings CS2a, CS2b, CS2c, and CS2d, which are located at a second height different from the first height from the substrate SUB, may be electrically connected to the second bit line BL2. The 3a-th, 3b-th, 3c-th, and 3d-th cell strings CS3a, CS3b, CS3c, and CS3d, which are located at a third height different from the first and second heights from the substrate SUB, may be electrically connected to the third bit line BL3.

Cell transistors which overlap an overlapped region on the substrate SUB when viewed along the third direction DR3 perpendicular to the substrate SUB (or which overlap an overlapped region on a plane formed by the first and second directions DR1, DR2 when viewed along the third direction DR3 perpendicular to the first and second directions DR1, DR2) may be electrically connected via the same vertical gate plug. For example, the 1a-th, 2a-th, and 3a-th cell strings CS1a, CS2a, and CS3a may be arranged in the third direction DR3 perpendicular to the substrate SUB. That is, the 1a-th, 2a-th, and 3a-th cell strings CS1a, CS2a, and CS3a may overlap each other when viewed along the third direction DR3 perpendicular to the substrate SUB. At this time, the first ground select transistors GST1 of the 1a-th, 2a-th, and 3a-th cell strings CS1a, CS2a, and CS3a may be connected through the same vertical gate plug. Similarly, cell transistors which overlap the same region or the overlapped region on the substrate SUB may be connected through the same vertical gate plug.

In some implementations, cell transistors located in the same plane (e.g., a plane formed in the second and third directions DR2 and DR3) perpendicular to the substrate SUB may be connected to the same control line. For example, the first ground select transistors GST1 of the plurality of cell strings CS1a, CS1b, CS1c, CS1d, CS2a, CS2b, CS2c, CS2d, CS3a, CS3b, CS3c, and CS3d may be formed in the same plane (e.g., a plane formed in the second and third directions DR2 and DR3) perpendicular to the substrate SUB, and may be connected to the first ground select line GSL1. That is, the first ground select transistors GST1 of the plurality of cell strings CS1a, CS1b, CS1c, CS1d, CS2a, CS2b, CS2c, CS2d, CS3a, CS3b, CS3c, and CS3d may be commonly controlled through the first ground select line GSL1. Similarly, the k-th ground select transistors GSTk of the plurality of cell strings CS1a, CS1b, CS1c, CS1d, CS2a, CS2b, CS2c, CS2d, CS3a, CS3b, CS3c, and CS3d may be formed in the same plane (e.g., a plane formed in the second and third directions DR2 and DR3) perpendicular to the substrate SUB, and may be connected to the k-th ground select line GSLk. That is, the k-th ground select transistors GSTk of the plurality of cell strings CS1a, CS1b, CS1c, CS1d, CS2a, CS2b, CS2c, CS2d, CS3a, CS3b, CS3c, and CS3d may be commonly controlled through the k-th ground select line GSLk. Similarly, the cell transistors DMC1, MC1, MC2, MC3, MC4, and DMC2 of the plurality of cell strings CS1a, CS1b, CS1c, CS1d, CS2a, CS2b, CS2c, CS2d, CS3a, CS3b, CS3c, and CS3d may be respectively located on planes perpendicular to the substrate SUB, the first dummy memory cells DMC1 may be connected to the first dummy word line WL1, the first memory cells MC1 may be connected to the first word line WL1, the second memory cells MC2 may be connected to a second word line WL2, the third memory cells MC3 may be connected to third word line WL3, the fourth memory cells MC4 may be connected to fourth word line WL4, and the second dummy memory cells DMC2 may be connected to second dummy word line DWL2.

The string select transistors which overlap the same region on the substrate SUB when viewed along the third direction DR3 perpendicular to the substrate SUB may be connected to the same control line. For example, the string select transistors SST of the 1a-th, 2a-th, and 3a-th cell strings CS1a, CS2a, and CS3a may be formed in the same region or may be formed to overlap the same region on the substrate SUB when viewed along the third direction DR3 perpendicular to the substrate SUB. The string select transistors SST of the 1a-th, 2a-th, and 3a-th cell strings CS1a, CS2a, and CS3a may be connected to the a-th string select line SSLa. The string select transistors SST of the 1b-th, 2b-th, and 3b-th cell strings CS1b, CS2b, and CS3b may be formed in the same region or may be formed to overlap the same region on the substrate SUB when viewed along the third direction DR3 perpendicular to the substrate SUB. The string select transistors SST of the 1b-th, 2b-th, and 3b-th cell strings CS1b, CS2b, and CS3b may be connected to the b-th string select line SSLb. The string select transistors SST of the 1c-th, 2c-th, and 3c-th cell strings CS1c, CS2c, and CS3c may be formed in the same region or may be formed to overlap the same region on the substrate SUB when viewed along the third direction DR3 perpendicular to on the substrate SUB. The string select transistors SST of the 1c-th, 2c-th, and 3c-th cell strings CS1c, CS2c, and CS3c may be connected to the c-th string select line SSLc. The string select transistors SST of the 1d-th, 2d-th, and 3d-th cell strings CS1d, CS2d, and CS3d may be formed in the same region or may be formed to overlap the same region on the substrate SUB when viewed along the third direction DR3 perpendicular to the substrate SUB. The string select transistors SST of the I d-th, 2d-th, and 3d-th cell strings CS1d, CS2d, and CS3d may be connected to the d-th string select line SSLd. Although not shown in the drawings, the plurality of cell strings CS1a, CS1b, CS1c, CS1d, CS2a, CS2b, CS2c, CS2d, CS3a, CS3b, CS3c, and CS3d of the first memory block BLK1 may further include other cell transistors (e.g., an erase control transistor). According to some implementations, the number of cell transistors included in the plurality of cell strings CS1a, CS1b, CS1c, CS1d, CS2a, CS2b, CS2c, CS2d, CS3a, CS3b, CS3c, and CS3d may vary.

As described above, the first memory block BLK1 according to some implementations of the present disclosure may have a three-dimensional structure stacked in a direction perpendicular to the substrate SUB. In some implementations, the first memory block BLK1 may include a plurality of cell strings CS1a, CS1b, CS1c, CS1d, CS2a, CS2b, CS2c, CS2d, CS3a, CS3b, CS3c, and CS3d, and each of the plurality of cell strings CS1a to CS3d may include a string channel parallel to the substrate SUB. The cell transistors of the plurality of cell strings CS1a, CS1b, CS1c, CS1d, CS2a, CS2b, CS2c, CS2d, CS3a, CS3b, CS3c, and CS3d may be connected in series in the first direction DR1 parallel to the substrate SUB, and the cell transistors formed in the same region or which overlap the same region on the substrate SUB when viewed along the third direction DR3 perpendicular to the substrate SUB may be electrically connected through the same vertical gate plug.

The first memory block BLK1 described with reference to FIG. 2 includes some examples, and the scope of the present disclosure is not limited thereto.

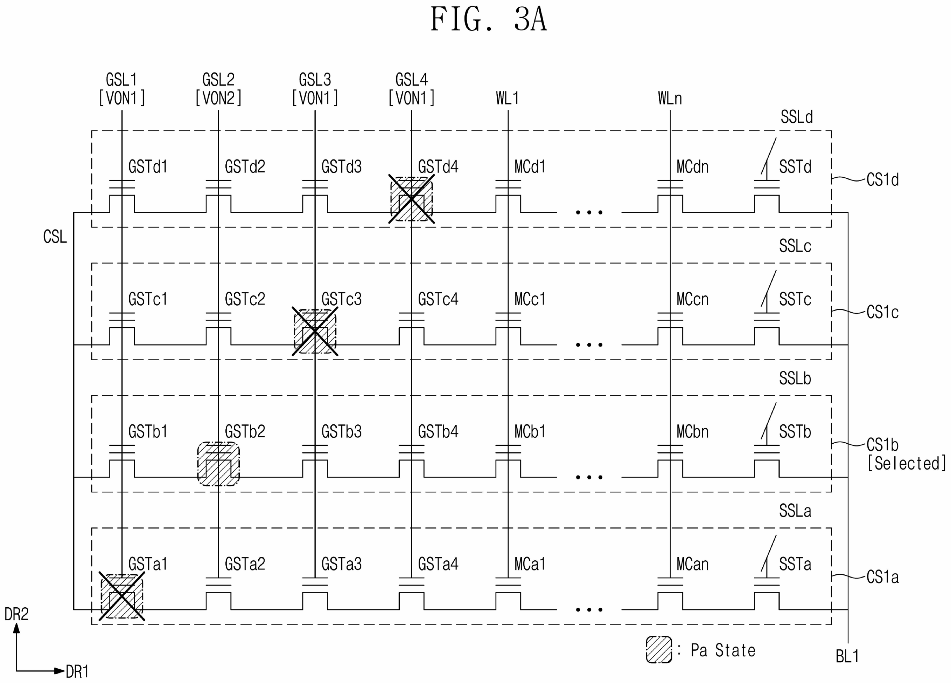

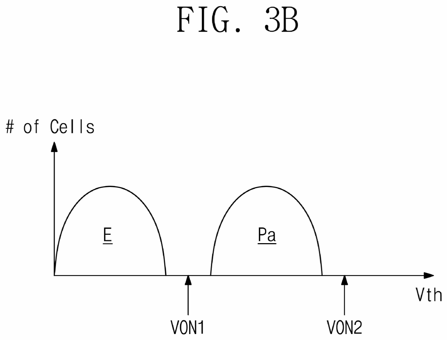

FIGS. 3A and 3B are diagrams for describing a method of controlling the first memory block of FIG. 2. Hereinafter for ease of description, implementations of the present disclosure are described with reference to a plurality of cell strings CS1a, CS1b, CS1c, and CS1d connected to the first bit line BL1. Alternatively, or additionally, some configurations (e.g., dummy memory cells, etc.) of the cell transistors included in each of the plurality of cell strings CS1a, CS1b, CS1c, and CS1d are omitted. However, the scope of the present disclosure is not limited thereto.

Hereinafter, for ease of description and brevity of the drawings, only some ground select lines GSL and some ground select transistors GST are shown in the drawings, but the scope of the present disclosure is not limited thereto. For example, although the ground select transistors or dummy ground select transistors shown in the following figure are shown as being directly connected to the common source line CSL, there may be additional ground select transistors or dummy ground select transistors between the shown ground select transistors and the common source line CSL.

In FIGS. 3A and 3B, for ease of description, it is assumed that the first memory block BLK1 has a 4SSL-1GSL structure. That is, the first memory block BLK1 may include four cell strings connected to one bit line BL, the four cell strings may share ground select lines GSL, and each of the four cell strings may be connected to its individual string select line. However, the scope of the present disclosure is not limited thereto.

Referring to FIGS. 1, 2, 3A, and 3B, the first memory block BLK1 may include 1a-th to 1d-th cell strings CS1a, CS1b, CS1c, and CS1d. The 1a-th to 1d-th cell strings CS1a, CS1b, CS1c, and CS1d may be formed on a plane parallel to the substrate SUB (that is, a plane formed by the first and second directions DR1 and DR2). That is, the 1a-th to 1d-th cell strings CS1a, CS1b, CS1c, and CS1d may be located at the same height from the substrate SUB.

The 1a-th cell string CS1a may include a plurality of ground select transistors GSTa1 to GSTa4, a plurality of memory cells MCa1 to MCan, and an a-string select transistor SSTa. The 1b-th cell string CS1b may include a plurality of ground select transistors GSTb1 to GSTb4, a plurality of memory cells MCb1 to MCbn, and a b-th string select transistor SSTb. The 1c-th cell string CS1c may include a plurality of ground select transistors GSTc1 to GSTc4, a plurality of memory cells MCc1 to MCcn, and a c-string select transistor SSTc. The 1d-th cell string CS1d may include a plurality of ground select transistors GSTd1 to GSTd4, a plurality of memory cells MCd1 to MCdn, and a d-string select transistor SSTd.

The a1-st, b1-st, c1-st, and d1-st ground select transistors GSTa1, GSTb1, GSTc1, and GSTd1 arranged in the second direction DR2 may be commonly connected to the first ground select line GSL1. The a2-nd, b2-nd, c2-nd, and d2-nd ground select transistors GSTa2, GSTb2, GSTc2, and GSTd2 arranged in the second direction DR2 may be commonly connected to the second ground select line GSL2. The a3-rd, b3-rd, c3-rd, and d3-rd ground select transistors GSTa3, GSTb3, GSTc3, and GSTd3 arranged in the second direction DR2 may be commonly connected to the third ground select line GSL3. The a4-th, b4-th, c4-th, and d4-th ground select transistors GSTa4, GSTb4, GSTc4, and GSTd4 arranged in the second direction DR2 may be commonly connected to the fourth ground select line GSL4. The a1-st, b1-st, c1-st, and d1-st memory cells MCa1, MCb1, MCc1, and MCd1, arranged in the second direction DR2 may be commonly connected to the first word line WL1. The an-th, bn-th, cn-th, and dn-th memory cells MCan, MCbn, MCcn, and MCdn arranged in the second direction DR2 may be commonly connected to the n-th word line WLn. The a-th string select transistor SSTa may be connected to the a-th string select line SSLa, the b-th string select transistor SSTb may be connected to the b-th string select line SSLb, the c-th string select transistor SSTc may be connected to the c-th string select line SSLc, and the d-th string select transistor SSTd may be connected to the d-th string select line SSLd.

In some implementations, since the cell strings CS1a, CS1b, CS1c, and CS1d connected to the same first bit line BL1 share the ground select lines GSL1 to GSL4, in operations on a specific cell string, ground select transistors of other non-selected cell strings are turned on, thereby electrically connecting the non-selected cell strings to the common source line CSL. In this case, an increase in power consumption and a decrease in performance of the memory device 100 may occur.

To solve the above-described problem, a plurality of cell strings CS1a, CS1b, CS1c, and CS1d connected to the same first bit line BL1 may be controlled through respective ground select lines. In this case, the remaining non-selected cell strings, except the selected cell string, are electrically separated from the common source line CSL, thereby preventing an increase in power consumption and a decrease in performance. However, when the plurality of cell strings CS1a, CS1b, CS1c, and CS1d connected to the same first bit line BL1 are respectively controlled through individual ground select lines, the area and wiring complexity for forming the ground select lines may increase.

According to some implementations of the present disclosure, the ground select transistors of the plurality of cell strings CS1a, CS1b, CS1c, and CS1d may share a plurality of ground select lines. At this time, by differently setting the threshold voltage states of the plurality of cell strings and individually controlling the plurality of ground select lines, the non-selected cell string may be blocked from being electrically connected to the common source line CSL.

In some implementations, each of the ground select transistors GSTa1 to GSTd4 of the 1a-th to 1d-th cell strings CS1a, CS1b, CS1c, and CS1d may have a threshold voltage state of any one of the erase state E and the a-th program state Pa. At this time, while the memory device 100 is operating, one of the plurality of cell strings CS1a, CS1b, CS1c, and CS1d may be selected, and the remaining cell strings may be unselected. In this case, the threshold voltage of each of the plurality of ground select transistors GSTa1 to GSTd4 may be set so that the remaining non-selected cell strings, except the selected cell string, among the plurality of cell strings CS1a, CS1b, CS1c, and CS1d are not electrically connected to the common source line CSL.

For example, as shown in FIG. 3B, the threshold voltage or threshold voltage distribution in the a-th program state Pa may be higher than the threshold voltage or the threshold voltage distribution in an erase state E. In this case, the ground select transistor having the a-th program state Pa may be turned off by the first on-voltage VON1 and may be turned on by the second on-voltage VON2. The ground select transistor, in its erased state E, may be turned on by the first on-voltage, VON1, and may also be turned on by the second on-voltage, VON2.

In some implementations, the erase state E may refer to a threshold voltage distribution different from the a-th program state Pa. The erase state E may indicate a threshold voltage distribution lower than the a-th program state Pa. For example, a threshold voltage of the ground select transistors corresponding to the erase state E may be lower than a threshold voltage of ground select transistors corresponding to the a-th program state Pa. In some implementations, a threshold voltage of the ground select transistors corresponding to the erase state E may be different from a threshold voltage of an erase state of the memory cells MC.

As illustrated in FIG. 3A, the threshold voltages of the a1-st, b2-nd, c3-rd, and d4-th ground select transistors GSTa1, GSTb2, GSTc3, and GST4d among the plurality of ground select transistors GPSa1 to GSTd4 may be programmed or set to the a-th program state Pa. In some implementations, the threshold voltage of the ground select transistors may be set or programmed between an erase operation and a program operation of the first memory block BLK1. In some implementations, the threshold voltage of the ground select transistors may be set or programmed based on a program operation, a soft program operation, or the like for the ground select transistor.

In the implementation of FIG. 3A, by applying the first on-voltage VON1 or the second on-voltage VON2 to each of the plurality of ground select lines GSL1 to GSL4, the remaining non-selected cell strings except the selected cell string among the plurality of cell strings CSa, CSb, CSc, and CSd may not be electrically connected to the common source line CSL. For example, it is assumed that the 1b-th cell string CS1b is a selected cell string. In this case, a first on-voltage VON1 may be applied to the first, third, and fourth ground select lines GSL1, GSL3, and GSL4, and a second on-voltage VON2 may be applied to a second ground select line GSL2. As described above, the second on-voltage VON2 may be higher than the first on-voltage VON1.

All of the ground select transistors GSTb1, GSTb2, GSTb3, and GSTb4 of the 1b-th cell string CS1b may be turned on by the first on-voltage VON1 or the second on-voltage VON2 of the first to fourth ground select lines GSL1 to GSL4. The al-st ground select transistor GSTa1 may be turned off in response to the first on-voltage VON1 of the first ground select line GSL1, the c3-rd ground select transistor GSTc3 may be turned off in response to the first on-voltage VON1 of the third ground select line GSL3, and the d4-th ground select transistor GSTd4 may be turned off in response to the first on-voltage VON1 of the fourth ground select line GSL4.

In this case, the channel of the 1b-th cell string CS1b, which is the selected cell string, is electrically connected to the common source line CSL, and the 1a-th, 1c-th, and 1d-th cell strings CS1a, CS1c, and CS1d, which are the non-selected cell strings, may not be electrically connected to the common source line CSL.

As described above, according to some implementations of the present disclosure, a memory block of the memory device 100 may include a plurality of cell strings. Each of the plurality of cell strings may include a channel parallel to the substrate. The plurality of cell strings may be connected to the plurality of ground select lines via a vertical gate plug formed in a direction perpendicular to the substrate. The plurality of cell strings may share a plurality of ground select lines. At this time, the ground select transistors of the plurality of cell strings may have different threshold voltage states. In the operation of the memory device 100, ground select lines may be controlled to block non-selected cell strings from being electrically connected to the common source line CSL.

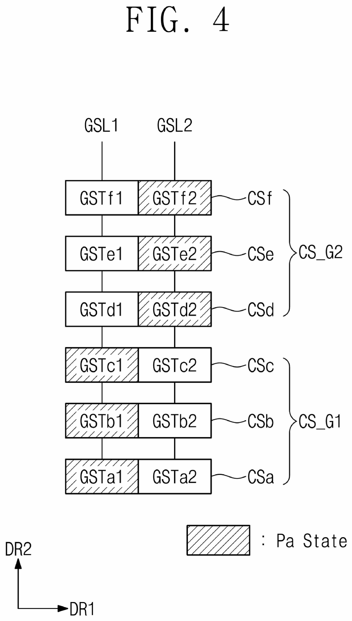

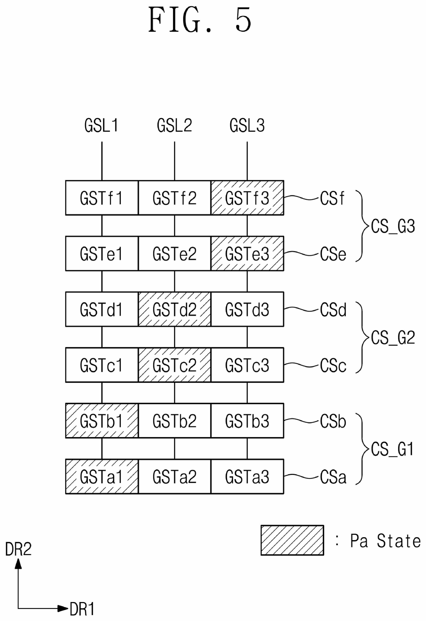

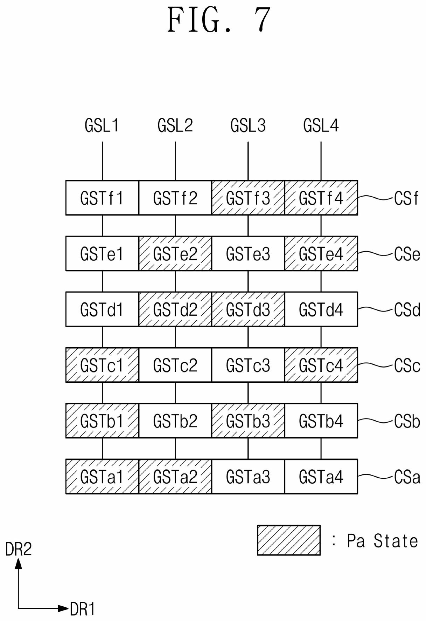

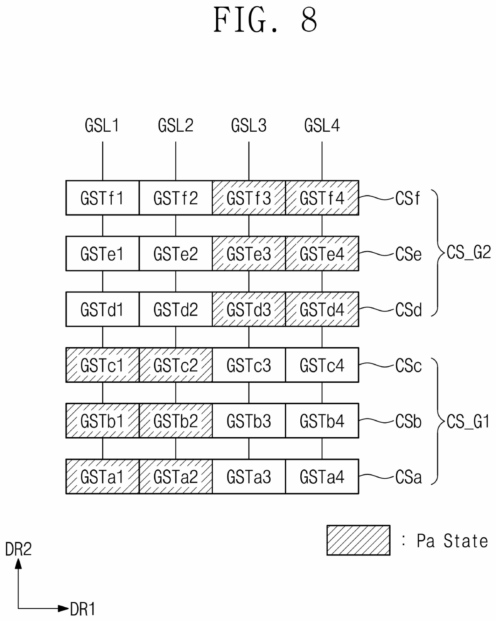

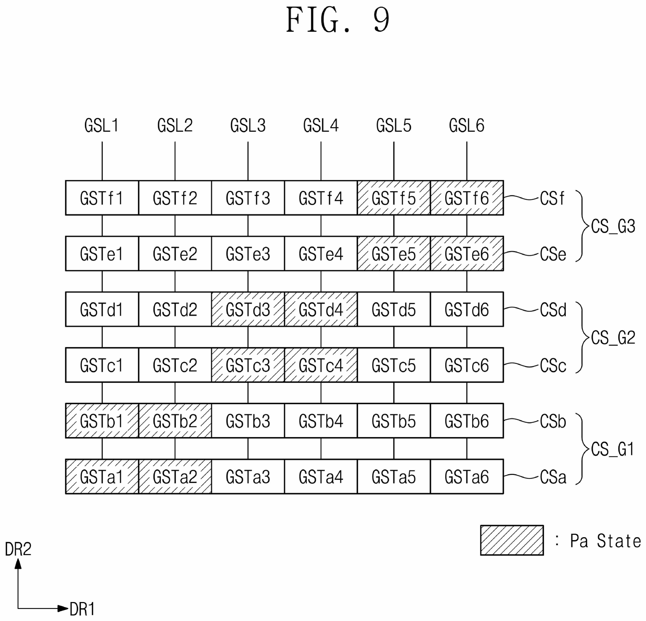

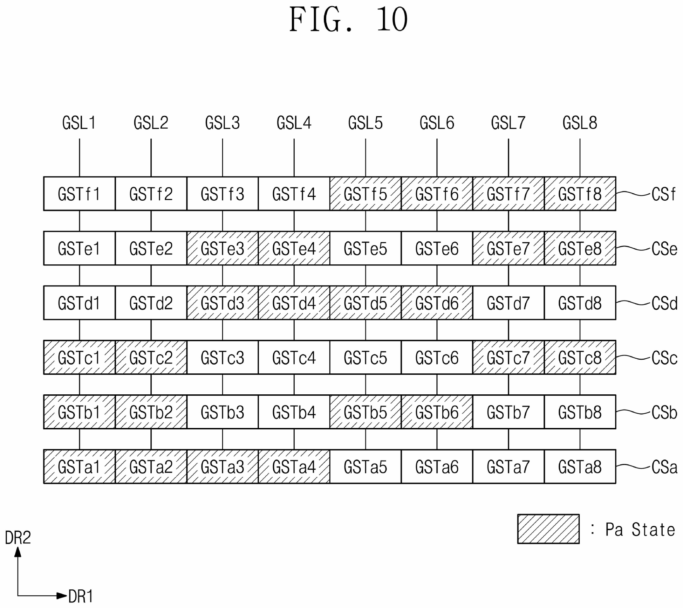

FIGS. 4, 5, 6, 7, 8, 9, and 10 are diagrams illustrating a ground select transistor coding pattern (GCP) of ground select transistors of the first memory block of FIG. 2.

Hereinafter, for brevity of the drawing, a ground select transistor coding pattern corresponding to the ground select transistors of the first memory block BLK1 is shown. However, it will be understood that the scope of the present disclosure is not limited thereto, and the ground select transistors of the memory device 100 may have a threshold voltage corresponding to the ground select transistor coding pattern described with reference to the following drawings, and the ground select transistors may be applied to the memory block BLK1 or the memory device 100 described above.

Alternatively, or additionally, in the following drawings, a plurality of cell strings may be connected to the same bit line. However, the scope of the present disclosure is not limited thereto, and cell strings sharing another bit line may also have the same or a similar ground select transistor coding pattern.

First, referring to FIGS. 1, 2, and 4, the first memory block BLK1 may include a-th to f-th cell strings CSa, CSb, CSc, CSd, CSe, and CSf. In operations of the memory device 100, the a-th to f-th cell strings CSa, CSb, CSc, CSd, CSe, and CSf may be controlled in units of cell string groups. For example, the first cell string group CS_G1 may include a-th to c-th cell strings CSa, CSb, and CSc. The second cell string group CS_G2 may include d-th to f-th cell strings CSd, CSe, and CSf.

When one of the cell strings CSa, CSb, and CSc included in the first cell string group CS_G1 is a selected cell string, at least some of the ground select transistors of the cell strings CSd, CSe, and CSf of the second cell string group CS_G2 may be turned off, and when one of the cell strings CSd, CSe, and CSf included in the second cell string Group CS_G2 is a selected cell string, at least some of the ground select transistor of the cell strings CSa, CSb, and CSc of the first cell string group CS_G1 may be turned off.

For example, the a-th cell string CSa may include a1-st and a2-nd ground select transistors GSTa1 and GSTa2 formed in the first direction DR1, the b-th cell string CSb may include b1-st and b2-nd ground select transistors GSTb1 and GSTb2 formed in the first direction DR1, the c-th cell string CSc may include c1-st and c2-nd ground select gates GSTc1 and GSTc2 formed in the first direction DR1, the d-th cell string CSd may include d1-st and d2-nd ground select transistors GSTd1 and GSTd2 formed in the first direction DR1, the e-th cell string CSe may include e1-st and e2-nd ground select dielectrics GSTe1 and GSTe2 formed in the first direction DR1, and the f-th cell string CSf may include f1-st and f2-nd ground select transistors GSTf1 and GSTf2 formed in the first direction DR1.

The ground select transistors GSTa1, GSTb1, GSTc1, GSTd1, GSTe1, and GSTf1 arranged in the second direction DR2 may be commonly connected to the first ground select line GSL1, and the ground select transistors GPSa2, GSTb2, GSTc2, GSTd2, GSTe2, and GSTf2 arranged in the second direction DR2 may be commonly connected to the second ground select line GSL2.

In the a-th, b-th, and c-th cell strings CSa, CSb, and CSc, the ground select transistors GSTa1, GSTb1, and GSTc1 connected to the first ground select line GSL1 may have the a-th program state Pa, and in the e-th, f-th, and g-th cell strings CSd, CSe, and CSf, the ground select transistors GSTd2, GSTe2, and GSTf2 connected to the second ground select line GSL2 may have the a-th program state Pa. The remaining ground select transistors GSTa2, GSTb2, GSTc2, GSTd1, GSTe1, and GSTf1 may have an erase state E.

In some implementations, it is assumed that the b-th cell string CSb included in the first cell string group GS1 is a selected cell string. In this case, the second on-voltage VON2 may be applied to the first ground select line GSL1, and the first on-voltage VON1 may be applied to a second ground select line GSL2. All of the ground select transistors GSTb1 and GSTb2 of the b-th cell string CSb, which is a selected cell string, may be turned on by the voltages of the first and second ground select lines GSL1 and GSL2. On the other hand, in the second cell string group CS_G2 in which the selected cell string is not included, the ground select transistors GSTd2, GSTe2, and GSTf2 connected to the second ground select line GSL2 may be turned off by the voltage of the first ground select line GSL1. That is, in the second cell string group CS_G2 in which the selected cell string is not included, the cell strings CSd, CSe, and CSf are not connected to the common source line CSL.

Next, referring to FIGS. 1, 2, and 5, the first memory block BLK1 may include a-th to f-th cell strings CSa, CSb, CSc, CSd, CSe, and CSf. In operations of the memory device 100, the a-th to f-th cell strings CSa, CSb, CSc, CSd, CSe, and CSf may be controlled in units of cell string groups. For example, the first cell string group CS_G1 may include the a-th and b-th cell strings CSa and CSb. The second cell string group CS_G2 may include the c-th and d-th cell strings CSc and CSd. The third cell string group CS_G3 may include the e-th and f-th cell strings CSe and CSf. When one of the cell strings CSa and CSb included in the first cell string group CS_G1 is a selected cell string, at least some of the ground select transistors of the cell strings CSd, CSe, and CSf of the second and third cell string groups CS_G2 and CS_G3 may be turned off, when one of the cell strings CSc and CSd included in the second cell string group CS_G2 is a selected cell string, at least some the ground select transistor of the cell strings CSa, CSb, CSe, and CSf of the first and third cell strings groups CS_G1 and CS_G3, may be turned off, and when one of the cell Strings CSe and CSf included in the third cell string group CS_G3 is a selected cell string, at least part of the ground select transistors of the cell strings CSa, CSb, CSc, and CSd of the first and second cell string groups CS_1 and CS_G2 may be turned off.

For example, the ground select transistors GSTa1 and GSTb1 connected to the first ground select line GSL1 among the ground select transistors GSTa1 to GSTa3 and GSTb1 to GSTb3 of the a-th and b-th cell strings CSa and CSb included in the first cell string group CS_G1 may have the a-th program state Pa. The ground select transistors GSTc2 and GSTd2 connected to the second ground select line GSL2 among the ground select transistors GSTc1 to GSTc3 and GSTd1 to GSTd3 of the c-th and d-th cell strings CSc and CSd included in the second cell string group CS_G2 may have the a-th program state Pa. The ground select transistors GSTe3 and GSTf3 connected to the third ground select line GSL3 among the ground select transistors GSTe1 to GSTe3 and the GSTf1 to GSTf3 of the e-th and f-th cell strings CSe and CSf included in the third cell string group CS_G3 may have the a-th program state Pa. The remaining ground select transistors GSTa2, GSTa3, GSTb2, GSTb3, GSTc1, GSTc3, GSTd1, GSTd3, GSTe1, GSTe2, GSTf1, GSTf2 may have an erase state E.

At this time, it is assumed that the b-th cell string CSb of the first cell string group CS_G1 is a selected cell string. In this case, the second on-voltage VON2 may be applied to the first ground select line GSL1, and the first on-voltage VON1 may be applied to the second and third ground select lines GSL2 and GSL3. By the voltages of the first to third ground select lines GSL1 to GSL3, all of the ground select transistors GSTb1 to GSTb3 of the b-th cell string CSb, which is a selected cell string, may be turned on. On the other hand, in the c-th and d-th cell strings CSc and CSd of the second cell string group CS_G2 in which the selected cell string is not included, the ground select transistors GSTc2 and GSTd2 connected to the second ground select line GSL2 may be turned off, and in the e-th and f-th cell string (CSe and CSf) of the third cell string group CS_G3 in which the selected cells string is not included, the ground select transistor GSTe3 and GSTf3 connected to the third ground select line GSL3 may be turned off. In the second and third cell string groups CS_G2 and CS_G3 in which the selected cell string is not included, the cell strings CSc, CSd, CSe, and CSf are not connected to the common source line CSL.

Next, referring to FIGS. 1, 2, and 6, the first memory block BLK1 may include a-th to f-th cell strings CSa, CSb, CSc, CSd, CSe, and CSf. In operations of the memory device 100, the a-th to f-th cell strings CSa, CSb, CSc, CSd, CSe, and CSf may be individually controlled.

For example, in the a-th cell string CSa, the a1-st ground select transistor GSTa1 connected to the first ground select line GSL1 may have the a-th program state Pa; in the b-th cell string CSb, the b2-nd ground select transistor GSTb2 connected to the second ground select line GSL2 may have the a-th program state Pa; in the c-th cell string CSc, the c3-rd ground select transistor GSTc3 connected to the third ground select line GSL3 may have the a-th program state Pa; in the d-th cell string CSd, the d4-th ground select transistor GSTd4 connected to the fourth ground select line GSL4 may have the a-th program state Pa; and in the e-th cell string Ce, the e5-th ground select transistor GSTe5 connected to the fifth ground select line GSL5 may have the a-th program state Pa; and in the f-th cell string CSf, the f6-th ground select transistor GSTf6 connected to the sixth ground select line GSL6 may have the a programs state Pa. The remaining ground select transistors may have an erase state E.

In this case, it is assumed that the b-th cell string CSb is a selected cell string. In this case, the second on-voltage VON2 may be applied to the second ground select line GSL2, and the first on-voltage VON1 may be applied to the first and third to sixth ground select lines GSL1 and GSL3 to GSL6. All of the ground select transistors GSTb1 to GSTb6 of the b-th cell string CSb may be turned on by the voltages VON1 and VON2 of the first to sixth ground select lines GSL1 to GSL6. The a1-st ground select transistor GSTa1 of the a-th cell string CSa may be turned off by the first on-voltage VON1 of the first ground select line GSL1, the c3-rd ground select transistor GSTc3 of the c-th cell string CSc may be turned off, the d4-th ground select transistor GSTd4 of the d-th cell string CSd may be turned off, and the e5-th ground select transistor GSTe5 of the e-th cell string CSe may be turned off. That is, the a-th and c-th to f-th cell strings CSa and CSc, CSd, CSe, and CSf, which are unselected cell strings, are not connected to the common source line CSL.

As described above, according to some implementations of the present disclosure, the memory device 100 may include a plurality of memory blocks. Each of the plurality of memory blocks may include a plurality of cell strings. Each of the plurality of cell strings may include a channel or string channel formed in a direction parallel to the substrate. Each of the plurality of cell strings may be stacked in a direction perpendicular to the substrate. Each of the plurality of cell strings may include a plurality of cell transistors connected in series in a direction parallel to the substrate, and the plurality of cell transistors may be connected through a vertical gate plug formed in a direction perpendicular to the substrate.

At this time, the ground select transistors of the plurality of cell strings may share a plurality of ground select lines and may have different threshold voltage states. In this case, by controlling the plurality of ground select lines, the non-selected cell string can be blocked from being electrically connected to the common source line.

Hereinafter, for ease of description, detailed descriptions of configurations that overlap with those described above are omitted.

Referring to FIGS. 1, 2, and 7, the first memory block BLK1 may include a-th to f-th cell strings CSa, CSb, CSc, CSd, CSe, and CSf. In the a-th cell string CSa, the a1-st and a2-nd ground select transistors GSTa1 and GSTa2 connected to the first and second ground select lines GSL1 and GSL2 may have an a-th program state Pa. In the b-th cell string CSb, the b1-st and b3-rd ground select transistors GSTb1 and GSTb3 connected to the first and third ground select lines GSL1 and GSL3 may have the a-th program state Pa. In the c-th cell string CSc, the c1-st and c4-th ground select transistors GSTc1 and GSTc4 connected to the first and fourth ground select lines GSL1 and GSL4 may have the a-th program state Pa. In the d-th cell string CSd, the d2-nd and d3-rd ground select transistors GSTd2 and GSTd3 connected to the second and third ground select lines GSL2 and GSL3 may have the a-th program state Pa. In the e-th cell string CSe, the e2-nd and e4-th ground select transistors GSTe2 and GSTe4 connected to the second and fourth ground select lines GSL2 and GSL4 may have the a-th program state Pa. In the f-th cell string CSf, the f3-rd and f4-th ground select transistors GSTf3 and GSTf4 connected to the third and fourth ground select lines GSL3 and GSL4 may have the a-th program state Pa. The remaining ground select transistors may have an erase state E.

In this case, by controlling the first to fourth ground select lines GSL1 to GSL4, the unselected cell strings may not be connected to the common source line CSL. For example, it is assumed that the b-th cell string CSb is a selected cell string. In this case, the second on-voltage VON2 may be applied to the first and third ground select lines GSL1 and GSL3, and the first on-voltage VON1 may be applied to the second and fourth ground select lines GSL2 and GSL4.

By the voltages of the first to fourth ground select lines GSL1 to GSL4, all of the ground select transistors GSTb1, GSTb2, GSTb3, and GSTb4 of the b-th cell string CSb, which is a selected cell string, may be turned on. By the first on-voltage VON1 of the second ground select line GSL2, the a2-nd ground select transistor GSTa2 of the a-th cell string CSa, the d2-nd ground select transistor GSTd2 of the d-th cell string CSd, and the e2-nd ground select transistor GSTe2 of the e-th cell string CSe may be turned off. By the first on-voltage VON1 of the fourth ground select line GSL4, the c4-th ground select transistor GSTc4 of the c-th cell string CSc, the e4-th ground select transistor GSTe4 of the e-th cell string CSe, and the f4-th ground select capacitor GSTf4 of the f-th cell string CSf may be turned off. Therefore, the b-th cell string CSb, which is the selected cell string, is connected to the common source line CSL, and the a-th and c-th to f-th cell strings CSa, CSc, CSd, CSe, and CSf, which are the unselected cell strings, are not connected to the common source line CSL.

Next, referring to FIGS. 1, 2, and 8, the first memory block BLK1 may include a-th to f-th cell strings CSa, CSb, CSc, CSd, CSe, and CSf. In the a-th to c-th cell strings CSa, CSb, and CSc included in the first cell string group CS_G1, the ground select transistors GSTa1, GSTa2, GSTb1, GSTb2, GSTc1, and GSTc2 connected to the first and second ground select lines GSL1 and GSL2 may have an a-th program state Pa. In the d-th to f-th cell strings CSd, CSe, and CSf included in the second cell string group CS_G2, the ground select transistors GSTd3, GSTd4, GSTe3, GSTe4, GSTf3, and GSTf4 connected to the third and fourth ground select lines GSL3 and GSL4 may have the a-th program state Pa. The remaining ground select transistors may have an erase state E.

In some implementations, it is assumed that the b-th cell string CSb is a selected cell string. In this case, the second on-voltage VON2 may be applied to the first and second ground select lines GSL1 and GSL2, and the first on-voltage VON1 may be applied to the third and fourth ground select lines GSL3 and GSL4. By the voltages of the first and second ground select lines GSL1 and GSL2, all of the ground select transistors GSTb1, GSTb2, GSTb3, and GSTb4 of the b-th cell string CSb, which is a selected cell string, may be turned on. In the second cell string group CS_G2 in which the selected cell string is not included, the ground select transistors GSTd3, GSTd4, GSTe3, GSTe4, GSTf3, and GSTf4 connected to the third and fourth ground select lines GSL3 and GSL4 may be turned off. Therefore, the b-th cell string CSb that is the selected cell string is connected to the common source line CSL, and the non-selected cell strings CSd, CSe, and CSf included in the second cell string group CS_G2 that does not include the selected cell string are not connected to the common source line CSL.

Next, referring to FIGS. 1, 2, and 9, the first memory block BLK1 may include a-th to f-th cell strings CSa, CSb, CSc, CSd, CSe, and CSf. In the a-th and b-th cell strings CSa and CSb included in the first cell string group CS_G1, the ground select transistors GSTa1, GSTa2, GSTb1, and GSTb2 connected to the first and second ground select lines GSL1 and GSL2 may have an a-th program state Pa. In the c-th and d-th cell strings CSc and CSd included in the second cell string group CS_G2, the ground select transistors GSTc3, GSTc4, GSTd3, and GSTd4 connected to the third and fourth ground select lines GSL3 and GSL4 may have the a-th program state Pa. In the e-th and f-th cell strings CSe and CSf included in the third cell string group CS_G3, the ground select transistors GSTe5, GSTe6, GSTf5, and GSTf6 connected to the fifth and sixth ground select lines GSL5 and GSL6 may have the a-th program state Pa. The remaining ground select transistors may have an erase state E.

In some implementations, it is assumed that the b-th cell string CSb is a selected cell string. In this case, the second on-voltage VON2 may be applied to the first and second ground select lines GSL1 and GSL2, and the first on-voltage VON1 may be applied to the third to sixth ground select lines GSR3 to GSL6. By the voltages of the first to sixth ground select lines GSL1 to GSL6, all of the ground select transistors GSTb1 to GSTb6 of the b-th cell string CSb, which is a selected cell string, may be turned on. In the second cell string group CS_G2 in which the selected cell string is not included, all of the ground select transistors GSTd3, GSTd4, GSTe3, and GSTe4 connected to the third and fourth ground select lines GSL3 and GSL4 may be turned off. In the third cell string group CS_G3 in which the selected cell string is not included, all of the ground select transistors GSTe5, GSTe6, GSTf5, and GSTf6 connected to the fifth and sixth ground select lines GSL5 and GSL6 may be turned off. Therefore, the b-th cell string CSb that is the selected cell string is connected to the common source line CSL, and the non-selected cell strings CSc, CSe, and CSf included in the second and third cell string groups CS_G2 and CS_G3 that do not include the selected cell string are not connected to the common source line CSL.

Next, referring to FIGS. 1, 2, and 10, the first memory block BLK1 may include a-th to f-th cell strings CSa, CSb, CSc, CSd, CSe, and CSf. In the a-th cell string CSa, the ground select transistors GSTa1, GSTa2, GSTa3, and GSTa4 connected to the first, second, third, and fourth ground select lines GSL1, GSL2, GSL3, and GSL4 may have an a-th program state Pa. In the b-th cell string CSb, the ground select transistors GSTb1, GSTb2, GSTb5, and GSTb6 connected to the first, second, fifth, and sixth ground select lines GSL1, GSL2, GSL5, and GSL6 may have the a-th program state Pa. In the c-th cell string CSc, the ground select transistors GSTc1, GSTc2, GSTc7, and GSTc8 connected to the first, second, seventh, and eighth ground select lines GSL1, GSL2, GSL7, and GSL8 may have the a-th program state Pa. In the d-th cell string CSd, the ground select transistors GSTd3, GSTd4, GSTd5, and GSTd6 connected to the third, fourth, fifth, and sixth ground select lines GSL3, GSL4, GSL5, and GSL6 may have the a-th program state Pa. In the e-th cell string CSe, the ground select transistors GSTe3, GSTe4, GSTe7, and GSTe8 connected to the third, fourth, seventh, and eighth ground select lines GSL3, GSL4, GSL7, and GSL8 may have the a-th program state Pa. In the f-th cell string CSf, the ground select transistors GSTf5, GSTf6, GSTf7, and GSTf8 connected to the fifth, sixth, seventh, and eighth ground select lines GSL5, GSL6, GSL7, and GSL8 may have the a-th program state Pa. The remaining ground select transistors may have an erase state E.

In some implementations, it is assumed that the b-th cell string CSb is a selected cell string. In this case, the second on-voltage VON2 may be applied to the first, second, fifth, and sixth ground select lines GSL1, GSL2, GSL5, and GSL6, and the first on-voltage VON1 may be applied to the third, fourth, seventh, and eighth ground select lines GSL3, GSL4, GSL7, and GSL8. In this case, all of the ground select transistors GSTb1 to GSTb8 of the b-th cell string CSb, which is the selected cell string, may be turned on by the voltages of the first to eighth ground select lines GSL1 to GSL8. In the a-th, d-th, and e-th cell strings CSa, CSd, and CSe, which are unselected cell strings, the ground select transistors GSTa3, GSTa4, GSTd3, GSTd4, GSTe3, and GSTe4 connected to the third and fourth ground select lines GSL3 and GSL4 may be turned off by the first on-voltage VON1 of the third and fourth ground select lines GSL3 and GSL4. In the c-th, e-th, and f-th cell strings CSc, CSe, and CSf, which are non-selected cell strings, the ground select transistors GSTc7, GSTc8, GSTe7, GSTe8, GSTf7, and GSTf8 connected to the seventh and eighth ground select lines GSL7 and GSL8 may be turned off by the first on-voltage VON1 of the seventh and eighth ground select lines GSL7 and GSL8. Therefore, the b-th cell string CSb, which is the selected cell string, is connected to the common source line CSL, and the cell strings CSa, CSc, CSd, CSe, and CSf, which are the unselected cell strings, are not connected to the common source line CSL.

As described above, according to some implementations of the present disclosure, the memory device 100 includes a plurality of memory blocks, and each of the plurality of memory blocks may include a plurality of cell strings. Each of the plurality of cell strings may include a channel or string channel formed in a direction parallel to the substrate, and may include a plurality of cell transistors connected in series in a direction parallel to the substrate. The plurality of cell strings may be stacked in a direction perpendicular to the substrate, and the cell transistors of the plurality of cell strings may be connected through a vertical gate plug. The ground select transistors of each of the plurality of cell strings may have different threshold voltage states. By controlling the voltage of the ground select line, the unselected cell string can be electrically disconnected from the common source line. Accordingly, performance degradation or reliability degradation of the memory device can be prevented.

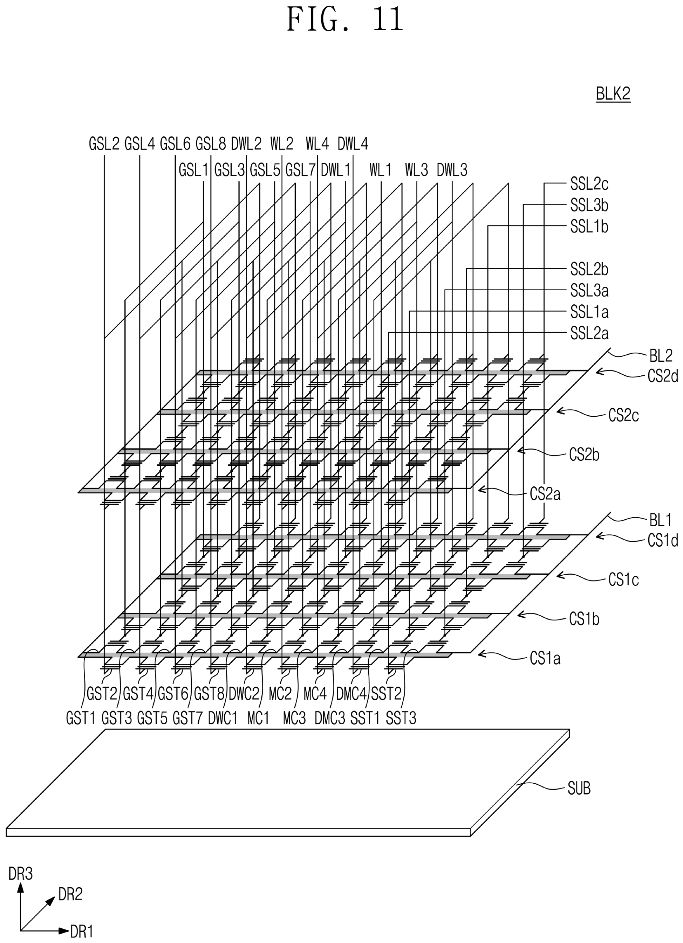

FIG. 11 is a circuit diagram illustrating a memory block included in the memory device of FIG. 1. For ease of description, detailed descriptions of the above-described components are omitted. An example of the structure of the second memory block BLK2 is described with reference to FIG. 11, but the scope of the present disclosure is not limited thereto. For example, each of a plurality of memory blocks included in the memory device 100 may have a structure of the first memory block BLK1 of FIG. 2 or a structure of the second memory block BLK2 of FIG. 11.

Referring to FIGS. 1 and 11, the second memory block BLK2 may include a plurality of cell strings CS1a, CS1b, CS1c, CS1d, CS2a, CS2b, CS2c, and CS2d. The plurality of cell strings CS1a, CS1b, CS1c, CS1d, CS2a, CS2b, CS2c, and CS2d may include a channel or a string channel formed in the first direction DR1 parallel to the substrate SUB. Each of the plurality of cell strings CS1a, CS1b, CS1c, CS1d, CS2a, CS2b, CS2c, and CS2d may include a plurality of cell transistors formed in a direction parallel to the substrate. The plurality of cell transistors may include a plurality of ground select transistors GST1 to GST8, dummy memory cells DMC1 and DMC2, memory cells MC1 to MC4, and string select transistors SST1 to SST3. The number of cell transistors included in each of the plurality of cell strings CS1a, CS1b, CS1c, CS1d, CS2a, CS2b, CS2c, and CS2d may vary in various ways.

In some implementations, a plurality of cell strings CS1a, CS1b, CS1c, CS1d, CS2a, CS2b, CS2c, and CS2d may be stacked in a third direction DR3 perpendicular to the substrate. For example, at a first height from the substrate SUB, 1a-th, 1b-th, 1c-th, and 1d-th cell strings CS1a, CS1b, CS1c, and CS1d may be formed. At a second height from the substrate SUB, 2a-th, 2b-th, 2c-th, and 2d-th cell strings CS2a, CS2b, CS2c, and CS2d may be formed.

In some implementations, cell strings located at the same height from the substrate SUB may be connected to the same bit line. For example, the 1a-th, 1b-th, 1c-th, and 1d-th cell strings CS1a, CS1b, CS1c, and CS1d located at the first height from the substrate SUB may be connected to a first bit line BL1. The 2a-th, 2b-th, 2c-th, and 2d-th cell strings CS2a, CS2b, CS2c, and CS2d located at the second height from the substrate SUB may be connected to a second bit line BL2.

In some implementations, each of the plurality of cell strings CS1a, CS1b, CS1c, CS1d, CS2a, CS2b, CS2c, and CS2d may share a vertical gate plug with cell strings which are adjacent in the second direction DR2. For example, the 1a-th cell string CS1a may be adjacent to the 1b-th cell string CS1b in the second direction DR2. In this case, some cell transistors in the 1a-th cell string CS1a may share a vertical gate plug with some cell transistors of the 1b-th cell string CS1b.

As more detailed, in FIG. 11, it is assumed that the first direction DR1 indicates a row direction and the second direction DR2 indicates a column direction. That is, the 1a-th cell string CS1a may be referred to as being located in a first row, and the 1b-th cell string CS1b may be referred to as being located in a second row. The first ground select transistors GST1 of the 1a-th and 1b-th cell strings CS1a and CS1b may be referred to as being located in a first column, and the second ground select transistors GST2 of the 1a-th and 1b-th cell strings CS1a and CS1b may also be referred to as being located in a second column. However, this is merely for easy description of implementations of the present disclosure, and the scope of the present disclosure is not limited thereto.

The cell transistors located in the odd-numbered column, among the cell transistors of the 1a-th and 1b-th cell strings CS1a and CS1b, may share a vertical gate plug with each other. For example, the first ground select transistors GST1 of the 1a-th and 1b-th cell strings CS1a and CS1b may share the same vertical gate plug. The third ground select transistors GST3 of the 1a-th and 1b-th cell strings CS1a and CS1b may share the same vertical gate plug. Similarly, the fifth ground select transistors GST5, the seventh ground select transistors GST7, the first dummy memory cells DMC1, the first memory cells MC1, the third memory cells MC3, the third dummy memory cells DMC3, the first string select transistor SST1, and the third string select transistor SST3 of the 1a-th and 1b-th cell strings CS1a and CS1b may share the same vertical gate plug, respectively.

Similar to what is described above, the 1b-th cell string CS1b and the 1c-th cell string CS1c may be adjacent to each other in the second direction DR2. In this case, the cell transistors located in the even-numbered column among the cell transistors of the 1b-th and 1c-th cell strings CS1b and CS1c, may share a vertical gate plug with each other. For example, the second ground select transistors GST2 of the 1b-th and 1c-th cell strings CS1b and CS1c may share the same vertical gate plug. The fourth ground select transistors GST4 of the 1b-th and 1c-th cell strings CS1b and CS1c may share the same vertical gate plug. Similarly, the sixth ground select transistors GST6, the eighth ground select transistors GST8, the second dummy memory cells DMC2, the fourth dummy memory cells DMC4, and the second string select transistors SST2 of the 1b-th and 1c-th cell strings CS1b and CS1c may share the same vertical gate plug, respectively.

As described above, in adjacent cell strings in the second direction DR2, the area for forming the cell strings may be reduced by some cell transistors sharing a vertical gate plug with each other. In some implementations, a memory block having the structure of the circuit diagram shown in FIG. 11 may be referred to as "a staggered structure".

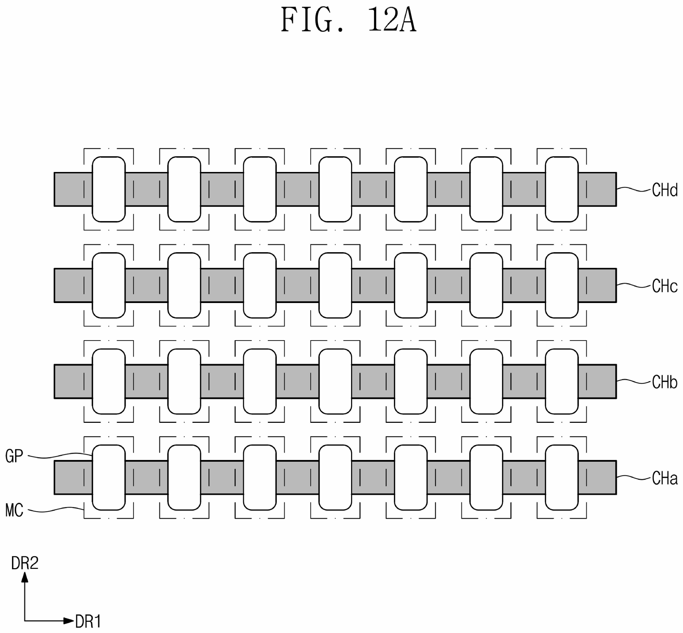

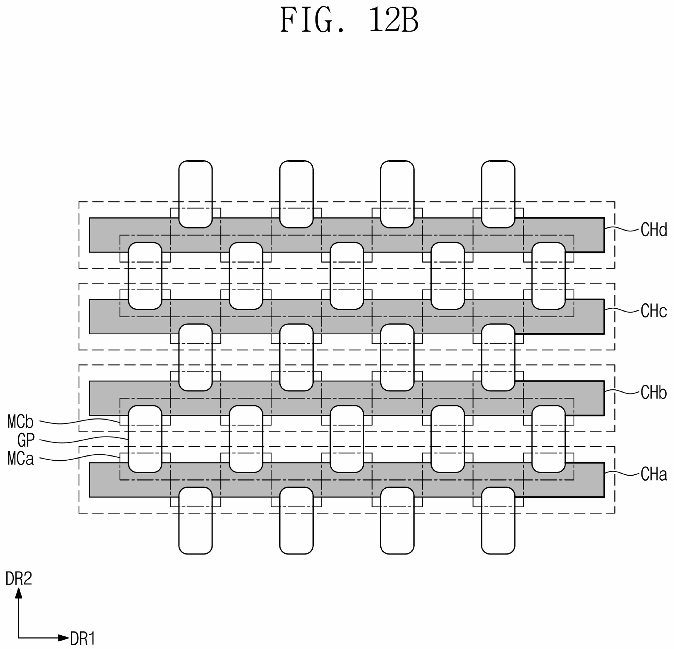

FIG. 12A is a diagram for describing a structure of the first memory block BLK1 of FIG. 2, and FIG. 12B is a diagram for describing a structure of the second memory block of FIG. 11.

Referring first to FIGS. 2 and 12A, the first memory block BLK1 may include a plurality of cell strings for the same height from the substrate SUB. The plurality of cell strings may each include a plurality of channels CHa, CHb, CHc, and CHd formed in the first direction DR1 parallel to the substrate SUB. The plurality of channels CHa, CHb, CHc, and CHd may be spaced apart from each other by a predetermined interval in the second direction DR2.

A vertical gate plug GP may be formed on an upper portion of each of the plurality of channels CHa, CHb, CHc, and CHd. In this case, one memory cell MC or select gates (for example, GST, SST, etc.) may be formed at a point where each of the plurality of channels CHa, CHb, CHc, and CHd and the vertical gate plug GP intersect. That is, one cell transistor may be formed through one channel and one vertical gate.

Next, referring to FIG. 12B, the second memory block BLK2 may include a plurality of cell strings for the same height from the substrate SUB. The plurality of cell strings may each include a plurality of channels CHa, CHb, CHc, and CHd formed in the first direction DR1 parallel to the substrate SUB. The plurality of channels CHa, CHb, CHc, and CHd may be spaced apart from each other by a predetermined interval in the second direction DR2.

Unlike the first memory block BLK1 of FIG. 12A, in the second memory block BLK2 of FIG. 12B, the vertical gate plug GP may be formed between a plurality of channels CHa, CHb, CHc, and CHd. For example, a vertical gate plug GP may be formed between the a-th and b-th channels CHa and CHb. Two memory cells MCa and MCb may be formed through one vertical gate plug GP. That is, the a-th memory cell MCa may be formed through the a-th channel CHa and the vertical gate plug GP, and the b-th memory cell MCb may be formed through the b-th channel CHb and the vertical gate plug GP. In other words, the a-th memory cell MCa on the a-th channel CHa and the b-th memory cell MCb on the b-th channel CHb may be controlled by the same vertical gate plug GP or share the same vertical gate plug GP.

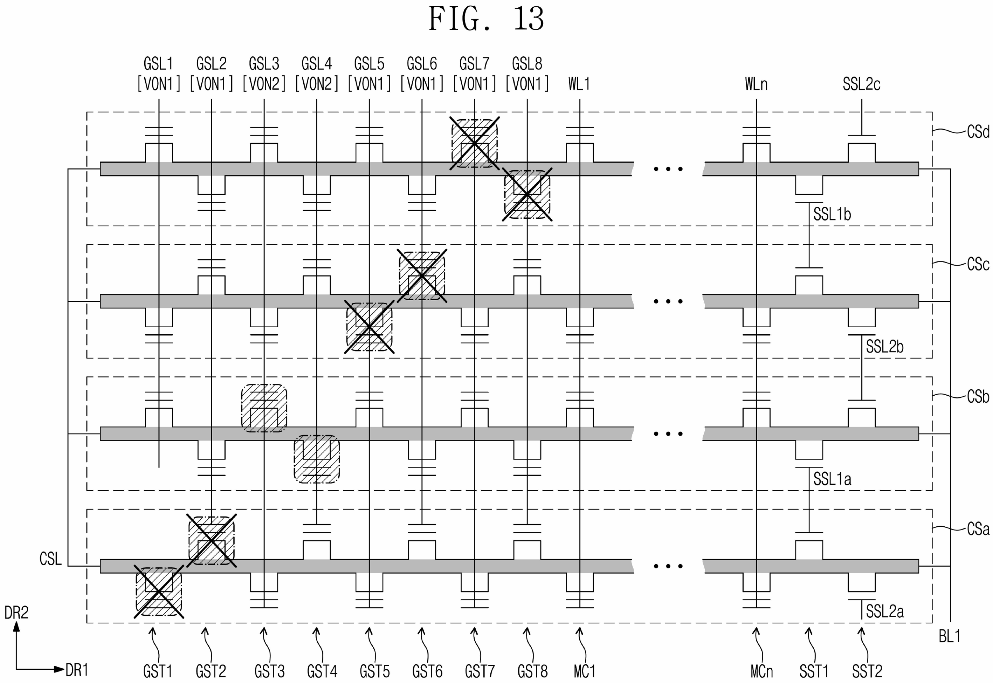

FIG. 13 is a diagram for describing a method of controlling the second memory block of FIG. 11. Hereinafter, for convenience of description, implementations of the present disclosure are described with reference to a plurality of cell strings CS1a, CS1b, CS1c, and CS1d connected to the first bit line BL1. In addition, some configurations (e.g., dummy memory cells, etc.) of the cell transistors included in each of the plurality of cell strings CS1a, CS1b, CS1c, and CS1d are omitted. However, the scope of the present disclosure is not limited thereto.

Referring to FIGS. 1, 11, and 13, the second memory block BLK2 may include a plurality of cell strings CSa, CSb, CSc, and CSd. The plurality of cell strings CSa, CSb, CSc, and CSd may be located at the same height from the substrate and may be connected to the first bit line BL1. The plurality of cell strings CSa, CSb, CSc, and CSd may include a plurality of channels formed in the first direction DR1 parallel to the substrate SUB, respectively.

Each of the plurality of cell strings CSa, CSb, CSc, and CSd may include a plurality of cell transistors. The plurality of cell transistors may be alternately disposed on both sides of a channel of each of the plurality of cell strings CSa, CSb, CSc, and CSd. For example, the a-th cell string CSa may include a plurality of ground select transistors GST1 to GST8, a plurality of memory cells MC1 to MCn, and a plurality of string select transistors SST1 and SST2. In the a-th cell string CSa, the first, third, fifth, and seventh ground select transistors GST1, GST3, GST5, and GST7, the first and N-th memory cells MC1 and MCn, and the second string select transistor SST2 may be disposed on one side of the channel of the a-th cell string CSa offset from a centre of the channel of the a-th cell string CSa in a direction opposite to the second direction DR2. In the a-th cell string CSa, the second, fourth, sixth, and eighth ground select transistors GST2, GST4, GST6, and GST8, and the first string select transistor SST1 may be disposed on the other side of the channel of the a-th cell string CSa offset from the centre of the channel of the a-th cell string CSa in the second direction DR2.

Similarly, the b-th cell string CSb may include a plurality of ground select transistors GST1 to GST8, a plurality of memory cells MC1 to MCn, and a plurality of string select transistors SST1 and SST2. In the b-th cell string CSb, the first, third, fifth, and seventh ground select transistors GST1, GST3, GST5, and GST7, the first and N-th memory cells MC1 and MCn, and the second string select transistor SST2 may be disposed on one side of the channel of the b-th cell string CSb offset from a centre of the channel of the b-th cell string CSb in the second direction DR2. In the b-th cell string CSb, the second, fourth, sixth, and eighth ground select transistors GST2, GST4, GST6, and GST8, and the first string select transistor SST1 may be disposed on the other side of the channel of the b-th cell string CSb offset from the centre of the channel of the b-th cell string CSb in a direction opposite to the second direction DR2.

The cell transistors located between the channel of the a-th cell string CSa and the channel of the b-th cell string CSb may be electrically connected to the same vertical gate plug or share the same vertical gate plug. For example, the second ground select transistors GST2 of the a-th and b-th cell strings CSa, CSb may share a first vertical gate plug. The second ground select transistors GST2 of the c-th and d-th cell strings CSc and CSd may share a second vertical gate plug. The first and second vertical gate plugs may be connected to the second ground select line GSL2 through separate wiring.

As described above, the second memory block BLK2 may include a plurality of cell strings. Each of the plurality of cell strings may include a string channel, and a plurality of vertical gate plugs may be provided between the string channels. In this case, at the same height from the substrate SUB, two cell transistors may be formed by one vertical gate plug. Such a memory block may be referred to as "a staggered structure".

In some implementations, the plurality of ground select transistors GST1 to GST8 of the plurality of cell strings CSa, CSb, CSc, and CSd may be programmed to have different threshold voltages. In this case, by controlling the plurality of ground select lines GSL1 to GSL8, it is possible to block the non-selected cell string from electrically connecting to the common source line CSL.

For example, the first and second ground select transistors GST1 and GST2 of the a-th cell string CSa may have the a-th program state Pa. The third and fourth ground select transistors GST3 and GST4 of the b-th cell string CSb may have the a-th program state Pa. The fifth and sixth ground select transistors GSTS and GST6 of the c-th cell string CSc may have the a-th program state Pa. The seventh and eighth ground select transistors GST7 and GST8 of the d-th cell string CSd may have the a-th program state Pa. When the ground select transistors are programmed as described above, the ground select lines GSL1 to GSL8 may be controlled to prevent the unselected cell string from being electrically connected to the common source line.

As an example, it is assumed that the b-th cell string CSb is a selected cell string. In this case, the second on-voltage VON2 may be applied to the third and fourth ground select lines GSL3 and GSL4, and the first on-voltage VON1 may be applied to the first, second, and fifth to eighth ground select lines GSL1, GSL2, and GSL5 to GSL8. In this case, all of the ground select transistors of the b-th cell string CSb may be turned on by the voltages of the first to eighth ground select lines GSL1 to GSL8. On the other hand, in response to the first on-voltage VON1 of the first and second ground select lines GSL1 and GSL2, the first and second ground select transistors GST1 and GST2 of the a-th cell string CSa may be turned off; in response to a first on-voltage VON1 of a fifth and sixth ground select line GSL5 and GSL6, the fifth and sixth ground select transistors GST5 and GST6 of the c-th cell string CSc may be turned off; and in response to a first on-voltage VON1 of seventh and eighth ground select lines GSL7 and GSL8, the seventh and eighth ground select transistors GST7 and GST8 of the d-th cell string CSd may be turned off. In this case, the b-th cell string CSb, which is the selected cell string, is electrically connected to the common source line CSL, and the a-th, c-th, and d-th cell strings CSa, CSc, and CSd, which are non-selected cell strings, may not be electrically connected to the shared source line CSL.

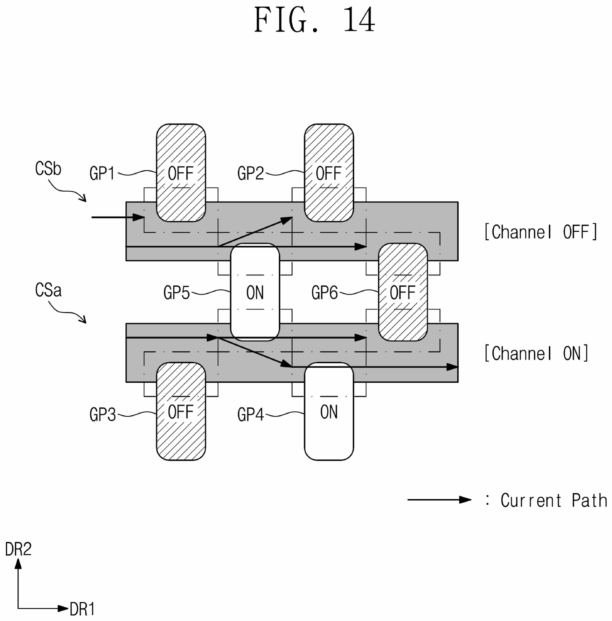

FIG. 14 is a diagram for describing a structure in which a string channel is blocked in the second memory block of FIG. 11. For ease of description, some components are shown schematically. Referring to FIGS. 11 and 14, the a-th and b-th cell strings CSa, CSb are shown. The a-th and b-th cell strings CSa and CSb may be connected to the first to sixth vertical gate plugs GP1 to GP6.

The first and second vertical gate plugs GP1 and GP2 may be located on a side in the channel of the b-th cell string CSb offset from a centre of the channel of the b-th cell string CSb in the second direction DR2. The third and fourth vertical gate plugs GP3 and GP4 may be located on a side in the channel of the a-th cell string CSa offset from a centre of the channel of the a-th cell string CSa in a direction opposite to the second direction DR2. The fifth and sixth vertical gate plugs GP5 and GP6 may be located between channels of the a-th and b-th cell strings CSa and CSb.

At this time, it is assumed that the cell transistors corresponding to the first, second, third, and sixth vertical gate plugs GP1, GP2, GP3, and GP6 are turned off, and the cell transistors corresponding to the fourth and fifth vertical gate plugs GP4 and GP5 are turned on.

In this case, in the channel of the b-th cell string CSb, the cell transistor corresponding to the fifth vertical gate plug GP5 is in the turn-on state, and thus the current path may be formed through the cell transistor corresponding to the fifth vertical gate plug GP5. However, in the channel of the b-th cell string CSb, since the cell transistors corresponding to the second and sixth vertical gate plugs GP2 and GP6 are in the turn-off state, the current path is blocked. That is, by turning off the cell transistors corresponding to the second and sixth vertical gate plugs GP2 and GP6, the channel of the b-th cell string CSb may be turned off.

In the channel of the a-th cell string CSa, since the cell transistor corresponding to the fifth vertical gate plug GP5 is in the turn-on state, the current path may be formed through the cell transistors corresponding to the fifth perpendicular gate plug GP5. At this time, in the channel of the a-th cell string CSa, the cell transistor corresponding to the sixth vertical gate plug GP6 is in the turned-off state, but the cell transistor corresponding to the fourth vertical gate plug GP4 is in the turned on state, so that the current path may be formed through the cell transistor corresponding a fourth vertical gate plug GP4. That is, by turning on the fifth and fourth vertical gate plugs GP5 and GP4, the channel of the a-th cell string CSa may be turned on.

As described above, in the structure of the second memory block BLK2 of FIG. 11, when at least two adjacent cell transistors in the same cell string are turned off, the channel of the cell string may be turned off.

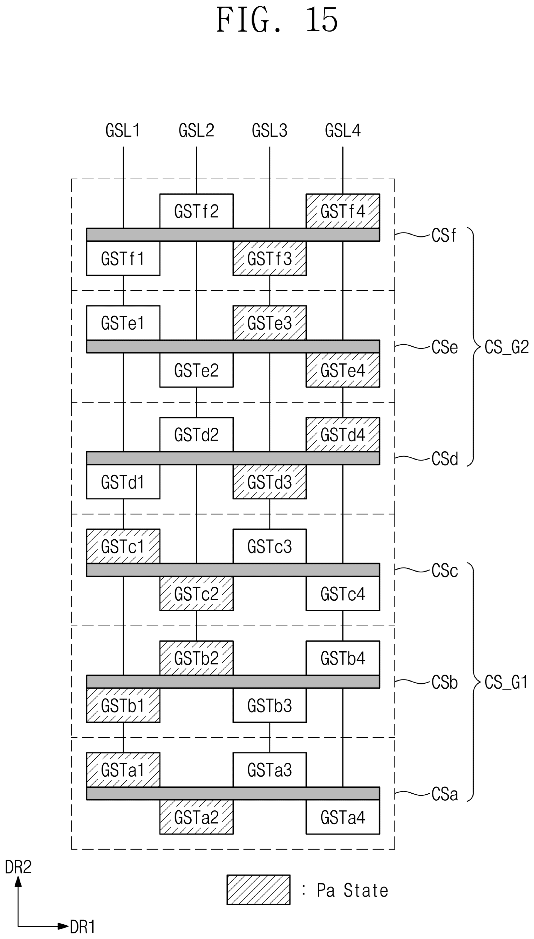

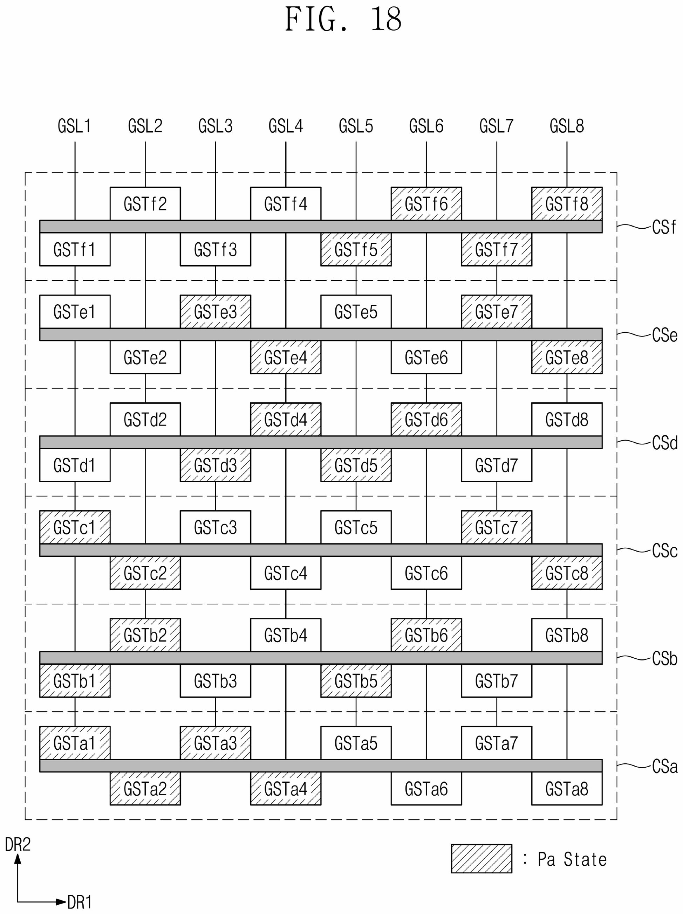

FIGS. 15, 16, 17, and 18 are diagrams illustrating a ground select transistor coding pattern (GCP) of ground select transistors of the second memory block of FIG. 11. Hereinafter, for brevity of the drawing, a ground select transistor coding pattern corresponding to the ground select transistors of the second memory block BLK2 is shown. However, it will be understood that the scope of the present disclosure is not limited thereto, and the ground select transistors of the memory device 100 may have a threshold voltage corresponding to the ground select transistor coding pattern described with reference to the following drawings, and the ground select transistors may be applied to the memory block BLK2 or the memory device 100 described above.

Hereinafter, ground select transistors of each cell string are shown disposed in a plane and offset alternately in the second direction DR2 and in the direction opposite to the second direction DR2, with respect to a centre of the string channel. At this time, the ground select transistors located between the string channels (i.e., ground select transistors which are adjacent to each other in the second direction DR2) may share the same vertical gate plug. It will be understood, however, that these illustrations are intended to readily illustrate implementations of the invention, and that implementations of the invention are not limited thereto.

First, referring to FIGS. 1, 11, and 15, the second memory block BLK2 may include a plurality of cell strings CSa, CSb, CSc, CSd, CSe, and CSf. The plurality of cell strings CSa, CSb, CSc, CSd, CSe, and CSf may include a plurality of ground select transistors GSTa1 to GSTf4. For example, the a-th cell string CSa may include the ground select transistors GSTa1 to GSTa4, the b-th cell string CSb may include the ground select transistors GSTb1 to GSTb4, the c-th cell string CSc may include the ground select transistors GSTc1 to GSTc4, the d-th cell string CSd may include the ground choice transistors GSTd1 to GSTd4, the e-th cell string CSe may include the ground picking transistors GSTe1 to GSTe4, and the f-th cell string CSf may include the ground choices transistors GSTf1 to GSTf4.

For the string channel of the a-th cell string CSa, the a1-st and a3-rd ground select transistors GSTa1 and GSTa3 may be located on the side of the string channel of the a-th cell string CSa offset from a centre of the string channel of the a-th cell string CSa in the second direction DR2, and the a2-nd and a4-th ground select transistors GSTa2 and GSTa4 may be located on a side of the string channel of the a-th cell string CSa offset from a centre of the string channel of the a-th cell string CSa in a direction opposite to the second direction DR2. For the string channel of the b-th cell string CSb, the b2nd and b4-th ground select transistors GSTb2 and GSTb4 may be located on a side of the string channel of the b-th cell string CSb offset from a centre of the string channel of the b-th cell string CSb in the second direction DR2, and the b1-th and b3-th ground select transistors GSTb1 and GSTb3 may be located on a side of the string channel of the b-th cell string CSb offset from a centre of the string channel of the b-th cell string CSb in a direction opposite to the second direction DR2. In this case, the a1-st and b1-st ground select transistors GSTa1 and GSTb1 may be adjacent to each other in the second direction DR2 and may share the same vertical gate plug. The arrangement and connection relationship of the remaining ground select transistors are similar to those described above, and thus a detailed description thereof is omitted.

In some implementations, the a1-st, b1-st, c1-st, d1-st, e1-st, and f1-st ground select transistors GSTa1, GSTb1, GSTc1, GSTd1, GSTe1, and GSTf1 may be connected to a first ground select line GSL1, the a2-nd, b2-nd, c2-nd, d2-nd, e2-nd, and f2-nd ground select transistors GPSa2, GSTb2, GSTc2, GSTd2, GSTe2, and GSTf2 may be connected to a second ground select line GSL2, the a3-rd, b3-rd, c3-rd, d3-rd, e3-rd, and f3-rd ground select transistors GSTa3, GSTb3, GSTc3, GSTd3, GSTe3, and GSTf3 may be connected to a third ground select line GLI3, and the a4-th, b4-th, c4-th, d4-th, e4-th, and f4-th ground select transistors GSTa4, GSTb4, GSTc4, GSTd4, GSTe4, and GSTf4 may be connected to a fourth ground select line GSL4.

In some implementations, in the operation of the memory device 100, the a-th to f-th cell strings CSa, CSb, CSc, CSd, CSe, and CSf may be controlled in units of cell string groups. For example, the first cell string group CS_G1 may include a-th to c-th cell strings CSa, CSb, and CSc. The second cell string group CS_G2 may include d-th to f-th cell strings CSd, CSe, and CSf.

In the a-th, b-th, and c-th cell strings CSa, CSb, and CSc, the ground select transistors GSTa1, GSTa2, GSTb1, GSTb2, GSTc1, and GSTc2 connected to the first and second ground select lines GSL1 and GSL2 may have an a-th program state Pa. In the d-th, e-th, and f-th cell strings CSd, CSe, and CSf, the ground select transistors GSTd3, GSTd4, GSTe3, GSTe4, GSTf3, and GSTf4 connected to the third and fourth ground select lines GSL3 and GSL4 may have the a-th program state Pa. The remaining ground select transistors may have an erase state E.

In this case, the cell strings of the cell string group, excluding the selected cell string, may not be connected to the common source line. For example, it is assumed that the b-th cell string CSb is a selected cell string. In this case, the second on-voltage VON2 may be applied to the first and second ground select lines GSL1 and GSL2, and the first on-voltage VON1 may be applied to a third and a fourth ground select line GSL3 and GSL4. In this case, all of the ground select transistors GSTb1, GSTb2, GSTb3, and GSTb4 of the b-th cell string CSb may be turned on, and ground select transistors GSTd3, GSTd4, GSTe3, GSTe4, GSTf3, and GSTf4 of the cell strings CSd, CSe, and CSf of the second cell string group CS_G2 may be turned off by the first on-voltage VON1 of the third and fourth ground select lines GSL3 and GSL4. In this case, in each of the cell strings CSd, CSe, and CSf of the second cell string group CS_G2, since at least two adjacent ground select transistors are turned off in the first direction DR1 (or the extension direction of the string channel), the string channels of the cell string (CSd, CSe, and CSf) of the second cell string group CS_G2 will be in an off state. In other words, the cell strings CSd, CSe, and CSf of the second cell string group CS_G2 are not electrically connected to the common source line CSL.

In some implementations, at least two ground select transistors adjacent to each other may have the same meaning as at least two ground select lines respectively connected to the at least two ground select transistors are adjacent to each other. In other words, the at least two adjacent ground select lines may be respectively connected to at least two adjacent ground select transistors.

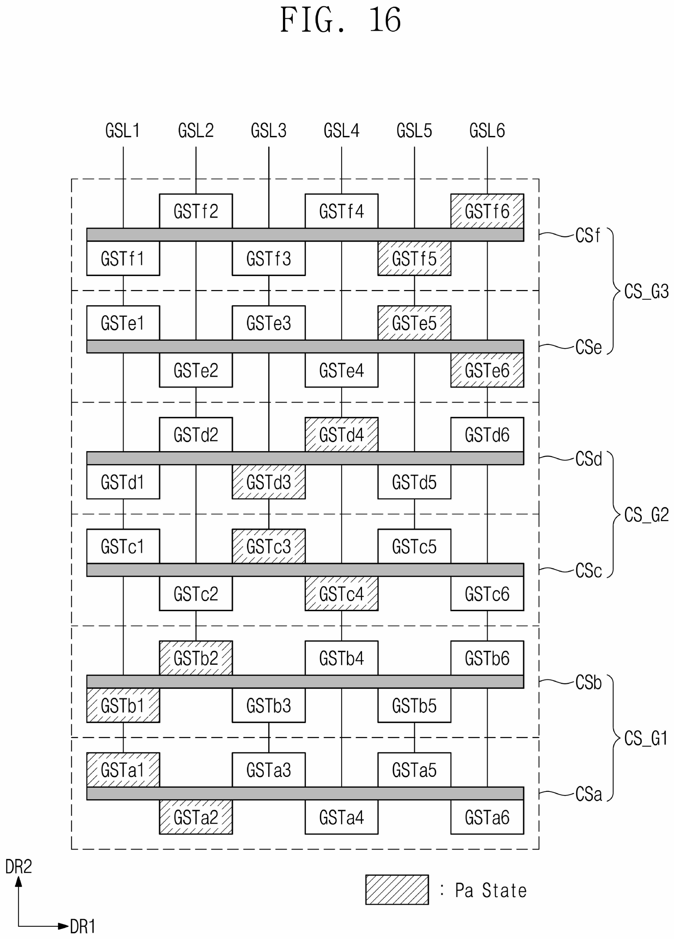

Next, referring to FIGS. 1, 11, and 16, the second memory block BLK2 may include a plurality of cell strings CSa, CSb, CSc, CSd, CSe, and CSf. The plurality of cell strings CSa, CSb, CSc, CSd, CSe, and CSf in FIG. 16 are similar to the structure of the plurality of cell Strings CSa, CSb, CSc, CSd, CSe, and CSf in FIG. 15, except that the number of ground select transistors and the number of ground select lines are different. For convenience of description, a detailed description of the structure of the plurality of cell strings CSa, CSb, CSc, CSd, CSe, and CSf in FIGS. 16A to 16F is omitted.

In some implementations, in the operation of the memory device 100, the a-th to f-th cell strings CSa, CSb, CSc, CSd, CSe, and CSf may be controlled in units of cell string groups. For example, the first cell string group CS_G1 may include a-th and b-th cell strings CSa and CSb. The second cell string group CS_G2 may include c-th and d-th cell strings CSc and CSd. The third cell string group CS_G3 may include e-th and f-th cell strings CSe and CSf.

In the a-th and b-th cell strings CSa and CSb of the first cell string group CS_G1, the ground select transistors GSTa1, GSTa2, GSTb1, and GSTb2 connected to the first and second ground select lines GSL1 and GSL2 may have an a-th program state Pa. In the c-th and d-th cell strings CSc and CSd of the second cell string group CS_G2, the ground select transistors GSTc3, GSTc4, GSTd3, and GSTd4 connected to the third and fourth ground select lines GSL3 and GSL4 may have the a-th program state Pa. In the e-th and f-th cell strings CSe and CSf of the third cell string group CS_G3, the ground select transistors GSTe5, GSTe6, GSTf5, and GSTf6 connected to the fifth and sixth ground select lines GSL5 and GSL6 may have the a-th program state Pa. The remaining ground select transistors may have an erase state E.

Similar to what is described above, cell strings of cell string groups that do not include a selected cell string are not connected to a common source line (CSL). For example, it is assumed that the b-th cell string CSb is a selected cell string. In this case, the second on-voltage VON2 may be applied to the first and second ground select lines GSL1 and GSL2, and the first on-voltage VON1 may be applied to the third to sixth ground select lines GSL3 to GSL6. In this case, all of the ground select transistors GSTb1 to GSTb6 of the b-th cell string CSb, which is the selected cell string, may be turned on. In the cell strings CSc and CSd of the second cell string group CS_G2, the ground select transistors GSTc3, GSTc4, GSTd3, and GSTd4 connected to the third and fourth ground select lines GSL3 and GSL4 are turned off, and in the cell strings CSe and CSf of the third cell string group CS_G3, the ground select transistor GTSe5, GSTe5, GSTf5, and GSTf6 connected to the fifth and sixth ground select lines GSL5 and GSL6 are turned off. That is, the non-selected cell strings CSc, CSd, CSe, and CSf of the second and third cell string groups CS_G2 and CS_G3 that do not include the selected cell string are not connected to the common source line CSL.

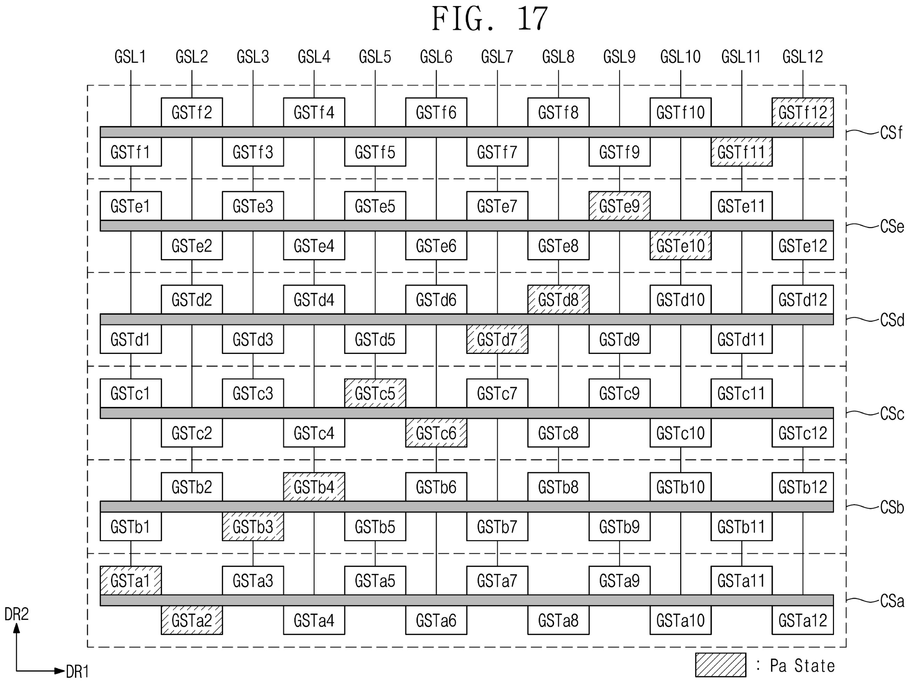

Next, referring to FIGS. 1, 11, and 17, the second memory block BLK2 may include a plurality of cell strings CSa, CSb, CSc, CSd, CSe, and CSf. The plurality of cell strings CSa, CSb, CSc, CSd, CSe, and CSf of FIG. 17 may have a structure similar to that described above, except that the number of ground select transistors and the number of ground select lines are different.

In the a-th cell string CSa, the ground select transistors GSTa1 and GSTa2 connected to the first and second ground select lines GSL1 and GSL2 may have the a-th program state Pa. In the b-th cell string CSb, the ground select transistors GSTb3 and GSTb4 connected to the third and fourth ground select lines GSL3 and GSL4 may have the a-th program state Pa. In the c-th cell string CSc, the ground select transistors GSTc5 and GSTc6 connected to the fifth and sixth ground select lines GSL5 and GSL6 may have the a-th program state Pa. In the d-th cell string CSd, the ground select transistors GSTd7 and GSTd8 connected to the 7th and 8th ground select lines GSL7 and GSL8 may have the a-th program state Pa. In the e-th cell string CSe, the ground select transistors GSTe9 and GSTe10 connected to the ninth and tenth ground select lines GSL9 and GSL10 may have the a-th program state Pa. In the f-th cell string CSf, the ground select transistors GSTf11 and GSTf12 connected to the 11th and 12th ground select lines GSL11 and GSL12 may have the a-th program state Pa. The remaining ground select transistors may have an erase state E.

In some implementations, it is assumed that the b-th cell string CSb is a selected cell string. In this case, the second on-voltage VON2 may be applied to the third and fourth ground select lines GSL3 and GSL4, and the first on-voltage VON1 may be applied to the remaining ground select lines GSL1, GSL2, and GSL5 to GSL12. All of the ground select transistors GSTb1 to GSTb12 of the b-th cell string CSb may be turned on by voltages of the plurality of ground select lines GSL1 to GSL12. The ground select transistors GSTa1 and GSTa2 of the a-th cell string CSa may be turned off by the first on-voltage VON1 of the first and second ground select lines GSL1 and GSL2; the ground select transistors GSTc5 and GSTc6 of the c-th cell string CSc may be turned off by the first on voltage VON1 of fifth and sixth ground select lines GNL5 and GSL6; the ground select transistor GSTd7 and GSTd8 of the d-th cell string CSd may be turned off by the first on-voltageVON1 of seventh and eighth ground select lines GSL7 and GSL8; the ground select transistors GSTe9 and GSTe10 of the e-th cell string CSe may be turned off by the first on-voltage VON1 of ninth and tenth ground select lines GSL9 and GSL10; and the ground select transistor GSTf11 and GSTf12 of the f-th cell string CSf may be turned off by the first on-voltage VON1 of eleventh and twelfth ground select lines GSL11 and GSL12. That is, the b-th cell string CSb, which is the selected cell string, is electrically connected to the common source line CSL, and the remaining cell strings CSa, CSc, CSd, CSe, and CSf, which are the unselected cell strings, are not electrically connected to the shared source line CSL.

Next, referring to FIGS. 1, 11, and 18, the second memory block BLK2 may include a plurality of cell strings CSa, CSb, CSc, CSd, CSe, and CSf. The plurality of cell strings CSa, CSb, CSc, CSd, CSe, and CSf of FIG. 17 may have a structure similar to that described above, except that the number of ground select transistors and the number of ground select lines are different.

In the a-th cell string CSa, the ground select transistors GSTa1, GSTa2, GSTa3, and GSTa4 connected to the first, second, third, and fourth ground select lines GSL1, GSL2, GSL3, and GSL4 may have the a-th program state Pa. In the b-th cell string CSb, the ground select transistors GSTb1, GSTb2, GSTb5, and GSTb6 connected to the first, second, fifth, and sixth ground select lines GSL1, GSL2, GSL5, and GSL6 may have the a-th program state Pa. In the c-th cell string CSc, the ground select transistors GSTc1, GSTc2, GSTc7, and GSTc8 connected to the first, second, seventh, and eighth ground select lines GSL1, GSL2, GSL7, and GSL8 may have the a-th program state Pa. In the d-th cell string CSd, the ground select transistors GSTd3, GSTd4, GSTd5, and GSTd6 connected to the third, fourth, fifth, and sixth ground select lines GSL3, GSL4, GSL5, and GSL6 may have the a-th program state Pa. In the e-th cell string CSe, the ground select transistors GSTe3, GSTe4, GSTe7, and GSTe8 connected to the third, fourth, seventh, and eighth ground select lines GSL3, GSL4, GSL7, and GSL8 may have the a-th program state Pa. In the f-th cell string CSf, the ground select transistors GSTf5, GSTf6, GSTf7, and GSTf8 connected to the fifth, sixth, seventh, and eighth ground select lines GSL5, GSL6, GSL7, and GSL8 may have the a-th program state Pa. The remaining ground select transistors may have an erase state E.

In some implementations, it is assumed that the b-th cell string CSb is a selected cell string. In this case, the second on-voltage VON2 may be applied to the first, second, fifth, and sixth ground select lines GSL1, GSL2, GSL5, and GSL6, and the first on-voltage VON1 may be applied to the third, fourth, seventh, and eighth ground select lines GSL3, GSL4, GSL7, and GSL8. In this case, all of the ground select transistors GSTb1 to GSTb8 of the b-th cell string CSb may be turned on. Ground select transistors GSTa3, GSTa4, GSTd3, GSTd4, GSTe3, and GSTe4 of the a-th, d-th, and e-th cell strings CSa, CSd, and CSe may be turned off by the first on-voltage VON1 of the third and fourth ground select lines GSL3 and GSL4, and ground select transistors GSTc7, GSTc8, GSTe7, GSTe8, GSTf7, and GSTf8 of the c-th, e-th, and f-th cell strings CSc, CSe, and CSf may be turned off, by the first on voltage VON1 of a 7th and an 8th ground select line GSL7 and GSL8. That is, the b-th cell string CSb, which is a selected cell string, may be electrically connected to the common source line CSL, and the remaining cell strings CSa, CSc, CSd, CSe, and CSf, which are non-selected cell strings, may not be electrically connected to a common source line CLS.

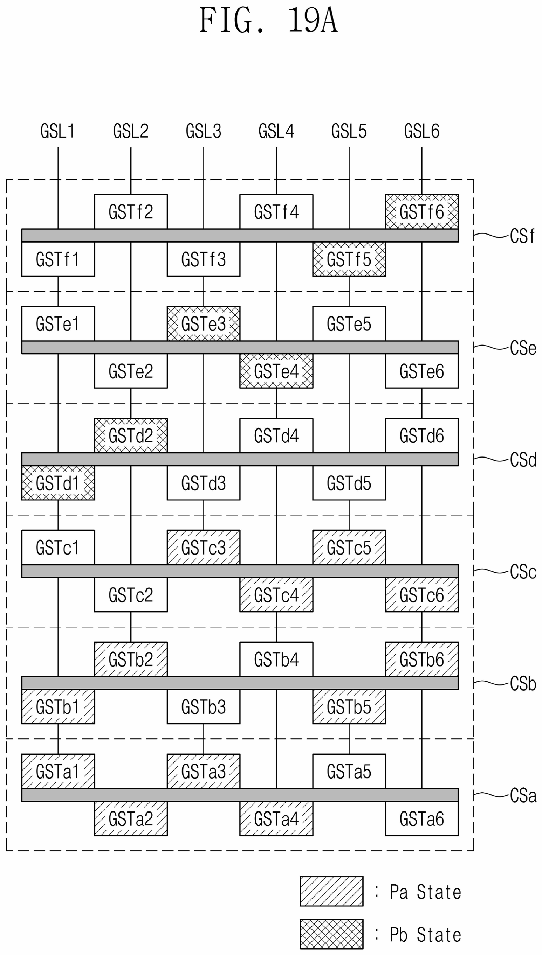

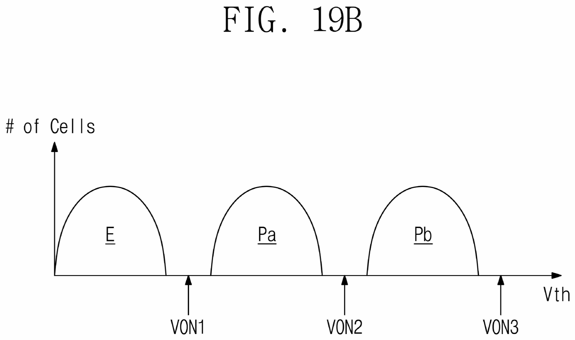

FIGS. 19A and 19B are diagrams illustrating a ground select transistor coding pattern (GCP) of ground select transistors of the second memory block BLK2 of FIG. 11. In the implementations described above, the ground select transistor has been described as having either an erase state E or an a-th program state Pa. However, the scope of the present disclosure is not limited thereto.

For example, as shown in FIGS. 19A and 19B, the ground select transistors may be programmed to have any one of an erase state E, an a-th program state Pa, and a b-th program state Pb. As an example, in the a-th cell string CSa, the ground select transistors GSTa1, GSTa2, GSTa3, and GSTa4 connected to the first, second, third, and fourth ground select lines GSL1, GSL2, GSL3, and GSL4 may have the a-th program state Pa. In the b-th cell string CSb, the ground select transistors GSTb1, GSTb2, GSTb5, and GSTb6 connected to the first, second, fifth, and sixth ground select lines GSL1, GSL2, GSL5, and GSL6 may have the a-th program state Pa. In the c-th cell string CSc, the ground select transistors GSTc3, GSTc4, GSTc5, and GSTc6 connected to the third, fourth, fifth, and sixth ground select lines GSL3, GSL4, GSL5, and GSL6 may have the a-th program state Pa. In the d-th cell string CSd, the ground select transistors GSTd1 and GSTd2 connected to the first and second ground select lines GSL1 and GSL2 may have the b-th program state Pb. In the e-th cell string CSe, the ground select transistors GSTe3 and GSTe4 connected to the third and fourth ground select lines GSL3 and GSL4 may have the b-th program state Pb. In the f-th cell string CSf, the ground select transistors GSTf5 and GSTf6 connected to the fifth and sixth ground select lines GSL5 and GSL6 may have the b-th program state Pb. The remaining ground select transistors may have the erase state E.

In some implementations, the memory device 100 may apply the first, second, or third on-voltages VON1, VON2, or VON3 to the ground select lines. When the ground select transistor is in the erased state E, the ground select transistor may be turned on by any one of the first, second, and third on-voltages VON1, VON2, and VON3. When the ground select transistor is in the a-th program state Pa, the ground select transistor may be turned on by any one of the second and third on-voltages VON2 and VON3, and may be turned off by the first on-voltage VON1. When the ground select transistor is in the b-th program state Pb, the ground select transistor may be turned on by the third on-voltage VON3, and may be turned off by any one of the first and second on-voltages VON1 and VON2.

In some implementations, it is assumed that the b-th cell string CSb is a selected cell string. In this case, the second on-voltage VON2 may be applied to the first, second, fifth, and sixth ground select lines GSL1, GSL2, GSL5, and GSL6, and the first on-voltage VON1 may be applied to the third and fourth ground select lines GSR3 and GSL4. In this case, all of the ground select transistors GSTb1 to GSTb6 of the b-th cell string CSb may be turned on. The ground select transistors GSTd1 and GSTd2 of the d-th cell string CSd may be turned off by the second on-voltage VON2 of the first and second ground select lines GSL1 and GSL2, the ground select transistors GSTa3, GSTa4, GSTc3, GSTc4, GSTe3, and GSTe4 of the a-th, c-th, and e-th cell strings CSa, CSc, and CSe may be turned off by the first on-voltage VON1 of the third and fourth ground select lines GSL3 and GSL4, and the ground select transistor GSTf5 and GSTf6 of the f-th cell string CSf may be turned off by the second on-voltage VON2 of the fourth and fifth ground select lines GSL5 and GSL6. Therefore, the b-th cell string CSb, which is a selected cell string, is electrically connected to the common source line CSL, and the remaining cell strings CSa, CSc, CSd, CSe, and CSf, which are non-selected cell strings, are not electrically connected to the shared source line CSL.

As described above, according to some implementations of the present disclosure, a memory device may include a plurality of memory blocks. Each of the plurality of memory blocks may include a plurality of cell strings. The plurality of cell strings may be stacked in a direction perpendicular to the substrate. Each of the plurality of cell strings may include a string channel elongated in a direction parallel to the substrate, and may include a plurality of cell transistors arranged in the string channel. The plurality of cell transistors may be connected to a vertical gate plug formed in a direction perpendicular to the substrate. In some implementations, one vertical gate plug may correspond to one or two cell transistors. The plurality of ground select transistors may share a plurality of ground select lines.

According to implementations of the present disclosure, in the above-described structure of a memory block, a plurality of ground select transistors may have different threshold voltage states. At this time, by controlling the voltages of the plurality of ground select lines according to the threshold voltage states of the plurality of ground select transistors, it is possible to block the non-selected cell strings from being electrically connected to the common source line during operation of the memory device. In this case, the area and wiring complexity for forming the ground select lines are reduced, and the power efficiency, performance, and reliability of the memory device can be improved.

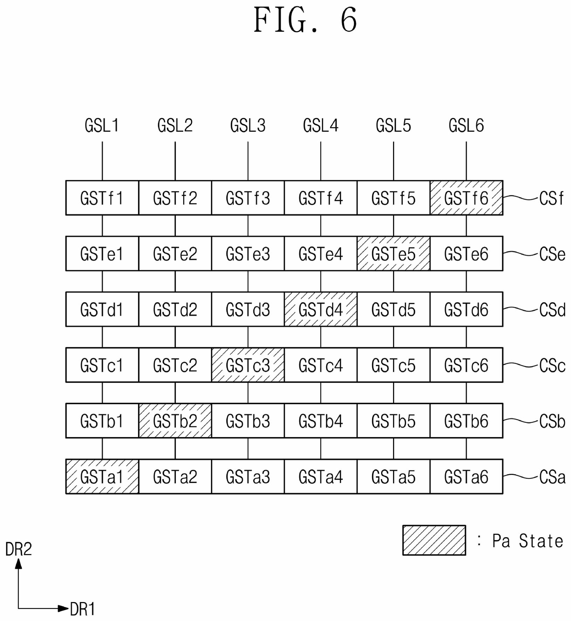

The implementations described above are some examples of the present disclosure, and the GSL coding pattern may be varied. For example, in the implementations described above, some ground select transistors of the plurality of ground select transistors have been described as having various program states. However, the scope of the present disclosure is not limited thereto, and some ground select transistors among a plurality of ground select transistors may have an erase state, and the remaining ground select transistors may have a program state. As an example, in the implementation of FIG. 6, the ground select transistors GSTa1, GSTb2, GSTc3, GSTd4, GSTe5, and GSTf6, which correspond to the a-th program state Pa, may have an erase state E, and the remaining ground select transistors may have the a-th program state Pa. That is, implementations in which the erase state E and the a-th program state Pa are inverted may be possible.

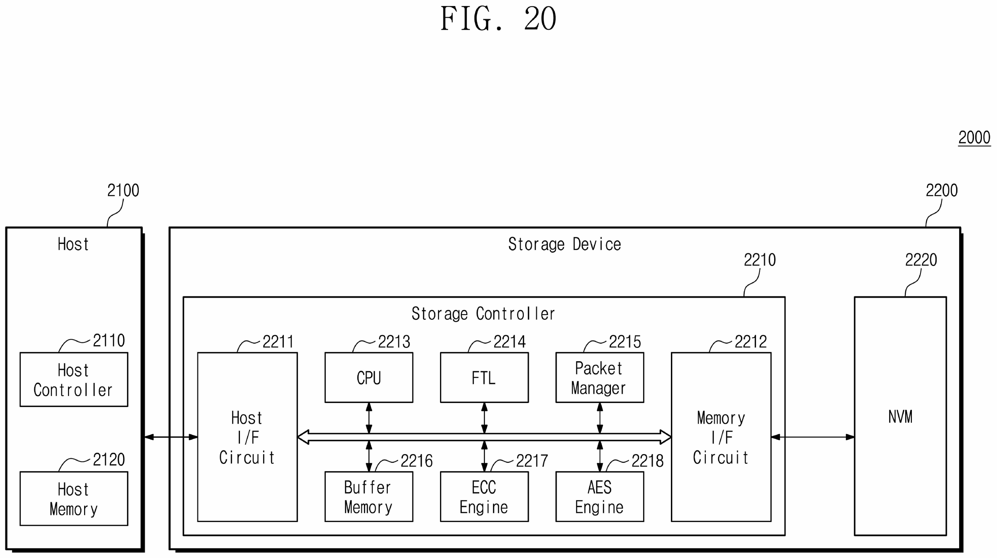

FIG. 20 is a block diagram illustrating a host-storage system 2000 according to an example implementation of the present disclosure.

The host storage system 2000 may include a host 2100 and a storage device 2200. Further, the storage device 2200 may include a storage controller 2210 and a nonvolatile memory (NVM) 2220. According to an example implementation, the host 2100 may include a host controller 2110 and a host memory 2120. The host memory 2120 may serve as a buffer memory configured to temporarily store data to be transmitted to the storage device 2200 or data received from the storage device 2200.

The storage device 2200 may include storage media configured to store data in response to requests from the host 2100. As an example, the storage device 2200 may include at least one of an SSD, an embedded memory, and a removable external memory. When the storage device 2200 is an SSD, the storage device 2200 may be a device that conforms to an NVMe standard. When the storage device 2200 is an embedded memory or an external memory, the storage device 2200 may be a device that conforms to a UFS standard or an eMMC standard. Each of the host 2100 and the storage device 2200 may generate a packet according to an adopted standard protocol and transmit the packet.

When the NVM 2220 of the storage device 2200 includes a flash memory, the flash memory may include a 2D NAND memory array or a 3D (or vertical) NAND (VNAND) memory array. As another example, the storage device 2200 may include various other kinds of NVMs. For example, the storage device 2200 may include magnetic RAM (MRAM), spin-transfer torque MRAM, conductive bridging RAM (CBRAM), ferroelectric RAM (FRAM), PRAM, RRAM, and various other kinds of memories.

According to some implementations, the host controller 2110 and the host memory 2120 may be implemented as separate semiconductor chips. Alternatively, in some implementations, the host controller 2110 and the host memory 2120 may be integrated in the same semiconductor chip. As an example, the host controller 2110 may be any one of a plurality of modules included in an application processor (AP). The AP may be implemented as a System on Chip (SoC). Further, the host memory 2120 may be an embedded memory included in the AP or an NVM or memory module located outside the AP.

The host controller 2110 may manage an operation of storing data (e.g., write data) of a buffer region of the host memory 2120 in the NVM 2220 or an operation of storing data (e.g., read data) of the NVM 2220 in the buffer region.

The storage controller 2210 may include a host interface 2211, a memory interface 2212, and a CPU 2213. Further, the storage controllers 2210 may further include a flash translation layer (FTL) 2214, a packet manager 2215, a buffer memory 2216, an error correction code (ECC) engine 2217, and an advanced encryption standard (AES) engine 2218. The storage controller 2210 may further include a working memory (not shown) in which the FTL 2214 is loaded. The CPU 2213 may execute the FTL 2214 to control data write and read operations on the NVM 2220.

The host interface 2211 may transmit and receive packets to and from the host 2100. A packet transmitted from the host 2100 to the host interface 2211 may include a command or data to be written to the NVM 2220. A packet transmitted from the host interface 2211 to the host 2100 may include a response to the command or data read from the NVM 2220. The memory interface 2212 may transmit data to be written to the NVM 2220 to the NVM 2220 or receive data read from the NVM 2220. The memory interface 2212 may be configured to comply with a standard protocol, such as Toggle or open NAND flash interface (ONFI).

The FTL 2214 may perform various functions, such as an address mapping operation, a wear-leveling operation, and a garbage collection operation. The address mapping operation may be an operation of converting a logical address received from the host 2100 into a physical address used to actually store data in the NVM 2220. The wear-leveling operation may be a technique for preventing excessive deterioration of a specific block by allowing blocks of the NVM 2220 to be uniformly used. As an example, the wear-leveling operation may be implemented using a firmware technique that balances erase counts of physical blocks. The garbage collection operation may be a technique for ensuring usable capacity in the NVM 2220 by erasing an existing block after copying the valid data of the existing block to a new block.

The packet manager 2215 may generate a packet according to a protocol of an interface, which consents to the host 2100, or parse various types of information from the packet received from the host 2100. In addition, the buffer memory 2216 may temporarily store data to be written to the NVM 2220 or data read from the NVM 2220. Although the buffer memory 2216 may be a component included in the storage controller 2210, the buffer memory 2216 may be outside the storage controller 2210.

The ECC engine 2217 may perform error detection and correction operations on read data read from the NVM 2220. More specifically, the ECC engine 2217 may generate parity bits for write data to be written to the NVM 2220, and the generated parity bits may be stored in the NVM 2220 together with write data. During reading data from the NVM 2220, the ECC engine 2217 may correct an error in the read data by using the parity bits read from the NVM 2220 together with the read data, and output error-corrected read data.

The AES engine 2218 may perform at least one of an encryption operation and a decryption operation on data input to the storage controller 2210 by using a symmetric-key algorithm.

In some implementations, the non-volatile memory 2220 of the storage device 2200 may be a NAND flash memory having a three-dimensional stacked structure. As an example, the nonvolatile memory 2200 may have a VGNAND (Vertical Gate NAND) structure including a string channel in a direction parallel to the substrate and a vertical gate plug in a direction perpendicular to the substrate. In some implementations, the non-volatile memory 2220 of the storage device 2200 may include a plurality of memory blocks, and ground select transistors of the plurality of memory blocks may have different threshold voltage states. At this time, the non-volatile memory 2220 may control the voltage of the ground select lines to control the on/off state of the ground select transistors. Through this, the non-volatile memory 2220 may allow or block non-selected cell strings from being electrically connected to a common source line. In some implementations, the threshold voltage state for the ground select transistors of the non-volatile memory 2220 may be controlled or managed by the storage controller 2210.

According to some implementations of the present disclosure, a memory device may include a substrate, and a plurality of first cell transistors connected in series in a first direction parallel to the substrate between a first bit line and a common source line. The plurality of first cell transistors may include a plurality of first string select transistors, a plurality of first memory cells, and a plurality of first ground select transistors. At least two adjacent ground select transistors of the plurality of ground select transistors may have a first program state, and the remaining first ground select transistors have an erase state.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations, one or more features from a combination can in some cases be excised from the combination, and the combination may be directed to a sub-combination or variation of a sub-combination.

The foregoing are specific implementations for carrying out the present disclosure. The present disclosure will include not only the implementations described above, but also implementations that can be simply changed in design or easily changed. The invention will also include techniques that can be readily modified and practiced using implementations. Therefore, the scope of the present disclosure should not be limited to the above-described implementations, but should be defined by the following claims as well as those equivalent to the claims of the present disclosure.

Embodiments are set out in the following clauses:
Clause 1. A memory device comprising:
   a substrate;
   a first cell string including a first string channel extending in a first direction parallel to the substrate, a first string select transistor connected to a first string select line, and a plurality of ground select transistors respectively connected to a plurality of ground select lines; and
   a second cell string including a second string channel extending in the first direction, a second string select transistor connected to a second string select line, and a plurality of ground select transistors respectively connected to the plurality of ground select lines,
   wherein each of the first and second cell strings is connected between a first bit line and a common source line,
   wherein first and second ground select transistors of the plurality of ground select transistors in the first cell string have a first threshold voltage state,
   wherein third and fourth ground select transistors of the plurality of ground select transistors in the second cell string have a second threshold voltage state different from the first threshold voltage state,
   wherein the first and third ground select transistors are connected to a first ground select line of the plurality of ground select lines, and
   wherein the second and fourth ground select transistors are connected to a second ground select line of the plurality of ground select lines.
Clause 2. The memory device of clause 1, wherein the first cell string comprises a plurality of first memory cells respectively connected to a plurality of word lines, and
   wherein the second cell string comprises a plurality of second memory cells respectively connected to the plurality of word lines.
Clause 3. The memory device of clause 1 or 2, wherein the first and second ground select transistors are adjacent to each other in the first direction, and
   wherein the third and fourth ground select transistors are adjacent to each other in the first direction.
Clause 4. The memory device of any preceding clause, wherein the first and second cell strings are located at a first height from the substrate in a direction perpendicular to the substrate.
Clause 5. The memory device of clause 4, comprising:
   a third cell string including a third string channel extending in the first direction parallel to the substrate, a third string select transistor connected to the first string select line, and a plurality of ground select transistors respectively connected to the plurality of ground select lines; and
   a fourth cell string including a fourth string channel extending in the first direction parallel to the substrate, a fourth string select transistor connected to the second string select line, and a plurality of ground select transistors respectively connected to the plurality of ground select lines, and
   wherein the third and fourth cell strings are connected between a second bit line and the common source line.
Clause 6. The memory device of clause 5, wherein the third and fourth cell strings are located at a second height from the substrate in the direction perpendicular to the substrate, wherein the second height is different from the first height.
Clause 7. The memory device of any preceding clause,
   wherein the first ground select transistor corresponds to a first vertical gate plug in a direction perpendicular to the substrate,
   wherein the second ground select transistor corresponds to a second vertical gate plug in the direction perpendicular to the substrate,
   wherein the third ground select transistor corresponds to a third vertical gate plug in the direction perpendicular to the substrate, and
   wherein the fourth ground select transistor corresponds to a fourth vertical gate plug in the direction perpendicular to the substrate.
Clause 8. The memory device of any one of clauses 1 to 6,
   wherein the first and third ground select transistors correspond to a first vertical gate plug in a direction perpendicular to the substrate,
   wherein the second ground select transistor corresponds to a second vertical gate plug in the direction perpendicular to the substrate, and
   wherein the fourth ground select transistor corresponds to a third vertical gate plug in the direction perpendicular to the substrate.
Clause 9. The memory device of clause 8, wherein the first vertical gate plug extends between the first and second string channels in the direction perpendicular to the substrate.
Clause 10. The memory device of any preceding clause, wherein based on the first cell string being selected, a first on-voltage is applied to the first and second ground select lines,
   wherein the first ground select transistor is configured to be turned on and the third ground select transistor is configured to be turned off by the first on-voltage of the first ground select line, and
   the second ground select transistor is configured to be turned on and the fourth ground select transistor is configured to be turned off by the first on-voltage of the second ground select line.
Clause 11. The memory device of any preceding clause,
   wherein fifth and sixth ground select transistors of the plurality of ground select transistors in the first cell string have the second threshold voltage state,
   wherein seventh and eighth ground select transistors of the plurality of ground select transistors in the second cell string have the first threshold voltage state,
   wherein the fifth and seventh ground select transistors are connected to a third ground select line of the plurality of ground select lines, and
   wherein the sixth and eighth ground select transistors are connected to a fourth ground select line of the plurality of ground select lines.
Clause 12. The memory device of clause 11, wherein based on the second cell string being selected, a first on-voltage is applied to the third and fourth ground select lines and a second on-voltage higher than the first on-voltage is applied to the first and second ground select lines,
   wherein the first and third ground select transistors are configured to be turned on by the second on-voltage of the first ground select line,
   wherein the second and fourth ground select transistors are configured to be turned on by the second on-voltage of the second ground select line,
   wherein the fifth ground select transistor is configured to be turned off and the seventh ground select transistor is configured to be turned on by the first on-voltage of the third ground select line, and
   wherein the sixth ground select transistor is configured to be turned off and the eighth ground select transistor is configured to be turned on by the first on-voltage of the fourth ground select line.
Clause 13. The memory device of any preceding clause when not dependent on clause 5, comprising:
   a third cell string including a third string channel extending in the first direction parallel to the substrate, a third string select transistor connected to a third string select line, and a plurality of ground select transistors respectively connected to the plurality of ground select lines, and
   wherein the third cell string is connected between the first bit line and the common source line.
Clause 14. The memory device of clause 13, wherein ninth and tenth ground select transistors of the plurality of ground select transistors in the third cell string have the second threshold voltage state,
   wherein the ninth ground select transistor is connected to the first ground select line of the plurality of ground select lines, and
   wherein the tenth ground select transistor is connected to the second ground select line of the plurality of ground select lines.
Clause 15. A memory device comprising:
   a substrate;
   a first cell string including a first string channel extending in a first direction parallel to the substrate, the first cell string being connected to a first bit line, a first string select line, and a plurality of ground select lines; and
   a second cell string including a second string channel extending in the first direction, the second cell string being connected to the first bit line, a second string select line, and the plurality of ground select lines,
   wherein based on the first cell string being selected, a first on-voltage is applied to first and second ground select lines of the plurality of ground select lines, and a second on-voltage lower than the first on-voltage is applied to remaining ground select lines, and
   wherein based on the second cell string being selected, the first on-voltage is applied to third and fourth ground select lines of the plurality of ground select lines, and the second on-voltage is applied to remaining ground select lines.

## Claims

1. A memory device (100) comprising:
a substrate (SUB);
a first cell string (CS1b) including a first string channel extending in a first direction (DR1) parallel to the substrate (SUB), a first string select transistor (SSTb) connected to a first string select line (SSLb), and a plurality of ground select transistors respectively connected to a plurality of ground select lines; and
a second cell string (CS1a) including a second string channel extending in the first direction (DR1), a second string select transistor (SSTa) connected to a second string select line (SSLa), and a plurality of ground select transistors respectively connected to the plurality of ground select lines,
wherein each of the first and second cell strings (CS1b, CS1a) is connected between a first bit line (BL1) and a common source line (CSL),
wherein first and second ground select transistors (GSTb1, GSTb2) of the plurality of ground select transistors in the first cell string (CS1b) have a first threshold voltage state (E),
wherein third and fourth ground select transistors (GSTa1, GSTa2) of the plurality of ground select transistors in the second cell string (CS1a) have a second threshold voltage state (Pa) different from the first threshold voltage state (E),
wherein the first and third ground select transistors (GSTb1, GSTa1) are connected to a first ground select line (GSL1) of the plurality of ground select lines, and
wherein the second and fourth ground select transistors (GSTb2, GSTa2) are connected to a second ground select line (GSL2) of the plurality of ground select lines.

2. The memory device (100) of claim 1, wherein the first cell string (CS1b) comprises a plurality of first memory cells (MCb1, ... MCbn) respectively connected to a plurality of word lines (WL1, ... WLn), and
wherein the second cell string (CS2a) comprises a plurality of second memory cells (MCa1, ... MCan) respectively connected to the plurality of word lines (WL1, ... WLn).

3. The memory device (100) of claim 1 or 2, wherein the first and second ground select transistors (GSTb1, GSTb2) are adjacent to each other in the first direction (DR1), and
wherein the third and fourth ground select transistors (GSTa1, GSTa2) are adjacent to each other in the first direction (DR1).

4. The memory device (100) of any preceding claim, wherein the first and second cell strings (CS1b, CS1a) are located at a first height from the substrate (SUB) in a direction (DR3) perpendicular to the substrate (SUB).

5. The memory device (100) of claim 4, comprising:
a third cell string (CS2b) including a third string channel extending in the first direction (DR1) parallel to the substrate (SUB), a third string select transistor (SSTb) connected to the first string select line (SSLb), and a plurality of ground select transistors respectively connected to the plurality of ground select lines ; and
a fourth cell string (CS2a) including a fourth string channel extending in the first direction (DR1) parallel to the substrate (SUB), a fourth string select transistor (SSTa) connected to the second string select line (SSLa), and a plurality of ground select transistors respectively connected to the plurality of ground select lines , and
wherein the third and fourth cell strings (CS2b, CS2a) are connected between a second bit line (BL2) and the common source line (CSL).

6. The memory device (100) of claim 5, wherein the third and fourth cell strings (CS2b, CS2a) are located at a second height from the substrate (SUB) in the direction (DR3) perpendicular to the substrate (SUB), wherein the second height is different from the first height.

7. The memory device (100) of any preceding claim,
wherein the first ground select transistor (GSTb1) corresponds to a first vertical gate plug (GP) in a direction (DR3) perpendicular to the substrate (SUB),
wherein the second ground select transistor (GSTb2) corresponds to a second vertical gate plug (GP) in the direction (DR3) perpendicular to the substrate (SUB),
wherein the third ground select transistor (GSTa1) corresponds to a third vertical gate plug (GP) in the direction (DR3) perpendicular to the substrate (SUB), and
wherein the fourth ground select transistor (GSTa2) corresponds to a fourth vertical gate plug (GP) in the direction (DR3) perpendicular to the substrate (SUB).

8. The memory device (100) of any one of claims 1 to 6,
wherein the first and third ground select transistors (GSTb1, GSTa1) correspond to a first vertical gate plug (GP) in a direction (DR3) perpendicular to the substrate (SUB),
wherein the second ground select transistor (GSTb2) corresponds to a second vertical gate plug (GP) in the direction (DR3) perpendicular to the substrate (SUB), and
wherein the fourth ground select transistor (GSTa2) corresponds to a third vertical gate plug (GP) in the direction (DR3) perpendicular to the substrate (SUB).

9. The memory device (100) of claim 8, wherein the first vertical gate plug (GP) extends between the first and second string channels in the direction (DR3) perpendicular to the substrate (SUB).

10. The memory device (100) of any preceding claim, wherein based on the first cell string (CS1b) being selected, a first on-voltage (VON1) is applied to the first and second ground select lines (GSL1, GSL2),
wherein the first ground select transistor (GSTb1) is configured to be turned on and the third ground select transistor (GSTa1) is configured to be turned off by the first on-voltage (VON1) of the first ground select line (GSL1), and
the second ground select transistor (GSTb2) is configured to be turned on and the fourth ground select transistor (GSTa2) is configured to be turned off by the first on-voltage (VON1) of the second ground select line (GSL2).

11. The memory device (100) of any preceding claim,
wherein fifth and sixth ground select transistors (GSTb3, GSTb4) of the plurality of ground select transistors in the first cell string (CS1b) have the second threshold voltage state (Pa),
wherein seventh and eighth ground select transistors (GSTa3, GSTa4) of the plurality of ground select transistors in the second cell string (CS1a) have the first threshold voltage state (E),
wherein the fifth and seventh ground select transistors (GSTb3, GSTa3) are connected to a third ground select line (GSL3) of the plurality of ground select lines , and
wherein the sixth and eighth ground select transistors (GSTb4, GSTa4) are connected to a fourth ground select line (GSL4) of the plurality of ground select lines .

12. The memory device (100) of claim 11, wherein based on the second cell string (CS1a) being selected, a first on-voltage (VON1) is applied to the third and fourth ground select lines (GSL3, GSL4) and a second on-voltage (VON2) higher than the first on-voltage (VON1) is applied to the first and second ground select lines (GSL1, GSL2),
wherein the first and third ground select transistors (GSTb1, GSTa1) are configured to be turned on by the second on-voltage (VON2) of the first ground select line (GSL1),
wherein the second and fourth ground select transistors (GSTb2, GSTa2) are configured to be turned on by the second on-voltage (VON2) of the second ground select line (GSL2),
wherein the fifth ground select transistor (GSTb3) is configured to be turned off and the seventh ground select transistor (GSTa3) is configured to be turned on by the first on-voltage (VON1) of the third ground select line (GSL3), and
wherein the sixth ground select transistor (GSTb4) is configured to be turned off and the eighth ground select transistor (GSTa4) is configured to be turned on by the first on-voltage (VON1) of the fourth ground select line (GSL4).

13. The memory device (100) of any preceding claim, comprising:
a fifth cell string including a fifth string channel extending in the first direction (DR1) parallel to the substrate (SUB), a fifth string select transistor connected to a third string select line, and a plurality of ground select transistors respectively connected to the plurality of ground select lines , and
wherein the fifth cell string is connected between the first bit line (BL1) and the common source line (CSL).

14. The memory device (100) of claim 13, wherein ninth and tenth ground select transistors of the plurality of ground select transistors in the fifth cell string have the second threshold voltage state (Pa),
wherein the ninth ground select transistor is connected to the first ground select line (GSL1) of the plurality of ground select lines, and
wherein the tenth ground select transistor is connected to the second ground select line (GSL2) of the plurality of ground select lines.

15. A memory device (100) comprising:
a substrate (SUB);
a first cell string (CS1a) including a first string channel extending in a first direction (DR1) parallel to the substrate (SUB), the first cell string (CS1a) being connected to a first bit line (BL1), a first string select line (SSLa), and a plurality of ground select lines ; and
a second cell string (CS1b) including a second string channel extending in the first direction (DR1), the second cell string (CS1b) being connected to the first bit line (BL1), a second string select line (SSLb), and the plurality of ground select lines,
wherein based on the first cell string (CS1a) being selected, a first on-voltage (VON2) is applied to first and second ground select lines (GSL1, GSL2) of the plurality of ground select lines, and a second on-voltage (VON1) lower than the first on-voltage (VON2) is applied to remaining ground select lines, and
wherein based on the second cell string (CS1b) being selected, the first on-voltage (VON2) is applied to third and fourth ground select lines (GSL3, GSL4) of the plurality of ground select lines, and the second on-voltage (VON1) is applied to remaining ground select lines.
